(19) Europäisches Patentamt
European Patent Office
Office européen des brevets

(11) EP 2 760 054 A1

(12) EUROPEAN PATENT APPLICATION
published in accordance with Art. 153(4) EPC

(43) Date of publication:
30.07.2014 Bulletin 2014/31

(51) Int Cl.:
H01L 31/0735 (2012.01)     H01L 31/0725 (2012.01)
H01S 5/40 (2006.01)

(21) Application number: 12832998.4

(22) Date of filing: 03.09.2012

(86) International application number:
PCT/JP2012/072330

(87) International publication number:
WO 2013/042525 (28.03.2013 Gazette 2013/13)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 21.09.2011  CN 201110281336

(71) Applicants:
• Sony Corporation
  Tokyo 108-0075 (JP)
• Suzhou Institute of Nano-Tech And Nano-Bionics
  Chinese Academy of Sciences
  Suzhou, Jiangsu 215125 (CN)
(72) Inventors:
• YOSHIDA Hiroshi
  Tokyo 108-0075 (JP)
• IKEDA Masao
  Tokyo 108-0075 (JP)

• UCHIDA Shiro
  Tokyo 108-0075 (JP)
• TANGE Takashi
  Tokyo 108-0075 (JP)
• KURAMOTO Masaru
  Tokyo 108-0075 (JP)
• ARIMOCHI Masayuki
  Shanghai 201203 (CN)
• YANG Hui
  Suzhou 215125 (CN)
• LU Shulong
  Suzhou 215125 (CN)
• ZHENG Xinhe
  Suzhou 215125 (CN)

(74) Representative: Müller - Hoffmann & Partner
Patentanwälte
St.-Martin-Strasse 58
81541 München (DE)

(54) MULTI-JUNCTION SOLAR CELL, COMPOUND SEMICONDUCTOR DEVICE, PHOTOELECTRIC CONVERSION ELEMENT, AND COMPOUND SEMICONDUCTOR LAYER LAMINATED STRUCTURE

(57) There is provided a multi-junction solar cell that reduces contact resistance of a junction portion and is capable of performing energy conversion with high efficiency. The multi-junction solar cell includes a plurality of sub-cells 11, 12, 13, and 14 that are laminated, the plurality of sub-cells 11, 12, 13, and 14 being configured of a plurality of compound semiconductor layers 11A, 11 B, 11C, 12A, 12B, 12C, 13A, 13B, 13C, 14A, 14B, and 14C that are laminated. Amorphous connection layers 20A and 20B made of electrically-conductive material are provided in at least one place between the sub-cells 12 and 13 adjacent to each other.

[ FIG. 3 ]

[STEP-130] (SUBSEQUENT STEP)

| | |
|---|---|
| 17 : WINDOW LAYER | |
| 14 : FOURTH SUB-CELL | 14C: n+−InGaP LAYER |
| | 14B: p −InGaP LAYER |
| | 14A: p+−InGaP LAYER |
| 16 : SECOND TUNNEL JUNCTION LAYER | |
| 13 : THIRD SUB-CELL | 13C: n+−GaAs LAYER |
| | 13B: p −GaAs LAYER |
| | 13A: p+−GaAs LAYER |
| 20B: CONNECTION LAYER (Ti LAYER) | |
| 20A: CONNECTION LAYER (Ti LAYER) | |
| 12 : SECOND SUB-CELL | 12C: n+−InGaAsP LAYER |
| | 12B: p −InGaAsP LAYER |
| | 12A: p+−InGaAsP LAYER |
| 15 : FIRST TUNNEL JUNCTION LAYER | |
| 11 : FIRST SUB-CELL | 11C : n+−InGaAs LAYER |
| | 11A2: p −InGaAs LAYER |
| | 11A1: p+−InGaAs LAYER |
| 31: SUBSTRATE FOR FILM-FORMATION /SUPPORT | |

EP 2 760 054 A1

**Description**

TECHNICAL FIELD

The present disclosure relates to a multi-junction (also called a tandem-type, a stack-type, or a lamination-type) solar cell, a compound semiconductor device, a photoelectric conversion device, and a compound-semiconductor-layer lamination structure that use a compound semiconductor.

BACKGROUND ART

As a compound semiconductor configured of two or more types of elements, many types exist depending on a combination of the elements. Also, by laminating a lot of compound semiconductor layers made of different materials, a compound semiconductor device having various functions and various physical properties are achievable. As an example thereof, a solar cell may be mentioned. Here, as a solar cell, a silicon-based solar cell that uses silicon as a semiconductor, a compound semiconductor solar cell that uses a compound semiconductor, an organic solar cell that uses an organic material, etc. may be mentioned. In particular, the compound semiconductor solar cell has been developed aiming further improvement in energy conversion efficiency.

As a means for improving energy conversion efficiency of the compound semiconductor solar cell, there are provided a method in which a plurality of sub-cells each configured of a thin-film solar cell that is configured of a plurality of compound semiconductor layers are laminated to form a multi-junction solar cell, a method in which an effective combination of compound semiconductor materials configuring the compound semiconductor layers are searched, etc. Each of compound semiconductors such as GaAs and InP has a unique band gap, and a wavelength of light to be absorbed is different depending on this difference in band gap. Therefore, by laminating a plurality of types of sub-cells, efficiency of absorption of solar light that has a wide wavelength range is improved. In lamination, a combination of lattice constants and physical property values (such as band gaps) of crystal structures of the compound semiconductors configuring the respective sub-cells is important.

By the way, most of the multi-junction solar cells under current consideration are classified into a lattice-matched type and a lattice-mismatched type. In the lattice-matched type, compound semiconductor layers are laminated that are made of compound semiconductors having lattice constants that are almost the same with one another. In the lattice-mismatched type, compound semiconductor layers are laminated that are made of compound semiconductors having lattice constants that are different from one another with the use of metamorphic growth accompanied by dislocation. However, in the metamorphic growth method, undesirable lattice mismatch inevitably occurs, and therefore, there is an issue that quality of the compound semiconductors is significantly lowered.

On the other hand, in recent years, there has been proposed a method of manufacturing a multi-junction solar cell that utilizes a substrate bonding technique in junction of compound semiconductor layers, and a four-junction solar cell that has a structure of $In_{0.48}Ga_{0.52}P/GaAs/InGaAsP/In_{0.53}Ga_{0.47}As$ has been reported.

This substrate bonding technique is a technique to form homojunction or heterojunction between the compound semiconductor layers to be joined, and may be classified, for example, into a direct bonding scheme in which different compound semiconductor layers are bonded directly to one another (for example, see Non-patent Literature 1: "Wafer Bonding and Layer Transfer Processes for High Efficiency Solar Cells", NCPV and Solar Program Review Meeting 2003), and a scheme in which compound semiconductor layers are joined with a connection layer in between. The substrate bonding technique has an advantage that it is not accompanied by an increase in threading dislocation. Existence of the threading dislocation leads to a not-preferable effect on electron performance of the compound semiconductor layers. In particular, the existence of the threading dislocation provides an easy diffusion path in the compound semiconductor layers as with a dopant and a recombination center, and causes a decrease in carrier density of the compound semiconductor layers. Also, the substrate bonding technique resolves the issue of lattice mismatch, and further avoids epitaxial growth caused by the lattice mismatch. Therefore, threading dislocation density that degrades the performance of the solar cell is largely reduced. In this substrate bonding technique, a covalent bonding is formed in an interface between different substances, in particular, in a hetero interface. At this time, it is important to perform a substrate bonding process at a temperature by which thermal variation does not exceed a dynamic barrier necessary for progression in threading dislocation.

In junction by the direct bonding scheme, semiconductor-semiconductor bonding is performed in a nuclear scale. Therefore, transparency, heat conductivity, heat resistance, and reliability of the junction portion are superior than those in a case where junction is formed with the use of metal paste, a glass raw material (frit), etc. In this direct bonding scheme, an integrated-type or two-terminal compound semiconductor device is allowed to be integrated to a module with simplicity equivalent to that in a solar cell configured of a single-junction device, specifically, only by alloying the respective compound semiconductor layers to be laminated.

CITATION LIST

NON-PATENT LITERATURE

Non-patent Literature 1: Wafer Bonding and Layer Transfer Processes for High Efficiency Solar Cells, NCPV and Solar Program Review Meeting 2003

SUMMARY OF THE INVENTION

However, in any of the above-described multi-junction solar cells, contact resistance of the junction portion is relatively high, and large improvement in energy conversion efficiency has not been obtained at present.

Therefore, it is desirable to provide a multi-junction solar cell, a compound semiconductor device, a photoelectric conversion device, and a compound-semiconductor-layer lamination structure that reduce the contact resistance of the junction portion and are capable of performing energy conversion with high efficiency.

A multi-junction solar cell of an embodiment of the present disclosure includes a plurality of sub-cells that are laminated, the plurality of sub-cells each being configured of a plurality of compound semiconductor layers that are laminated. An amorphous connection layer made of an electrically-conductive material is provided in at least one place between the sub-cells adjacent to each other.

A compound semiconductor device of an embodiment of the present disclosure includes a plurality of a plurality of compound semiconductor layers that are laminated. An amorphous connection layer made of an electrically-conductive material is provided in at least one place between the compound semiconductor layers adjacent to each other.

A photoelectric conversion device of an embodiment of the present disclosure includes a plurality of a plurality of compound semiconductor layers that are laminated. An amorphous connection layer made of an electrically-conductive material is provided in at least one place between the compound semiconductor layers adjacent to each other.

A compound-semiconductor-layer lamination structure of an embodiment of the present disclosure includes a plurality of a plurality of compound semiconductor layers that are laminated. An amorphous connection layer made of an electrically-conductive material is provided in at least one place between the compound semiconductor layers adjacent to each other.

In the multi-junction solar cell, the compound semiconductor device, the photoelectric conversion device, and the compound-semiconductor-layer lamination structure of an embodiment of the present disclosure, the amorphous connection layer made of the electrically-conductive material is provided. Therefore, contact resistance of a junction interface of the sub-cells or the compound semiconductor layers is reduced, and energy conversion efficiency is improved.

BRIEF DESCRIPTION OF THE DRAWINGS

[FIG. 1] (A) and (B) of FIG. 1 are conceptual diagrams of compound semiconductor layers and the like for explaining a method of manufacturing a multi-junction solar cell, a compound semiconductor device, a photoelectric conversion device, or a compound-semiconductor-layer lamination structure in Example 1.

[FIG. 2] (A) and (B) of FIG. 2 are conceptual diagrams of the compound semiconductor layers and the like for explaining the method of manufacturing the multi-junction solar cell, the compound semiconductor device, the photoelectric conversion device, or the compound-semiconductor-layer lamination structure in Example 1, following (B) of FIG. 1.

[FIG. 3] FIG. 3 is a conceptual diagram of compound semiconductor layers and the like for explaining the method of manufacturing the multi-junction solar cell, the compound semiconductor device, the photoelectric conversion device, or the compound-semiconductor-layer lamination structure in Example 1, following (B) of FIG. 2.

[FIG. 4] (A) and (B) of FIG. 4 are conceptual diagrams of multi-junction solar cells, compound semiconductor devices, photoelectric conversion devices, or compound-semiconductor-layer lamination structures in Example 2 and Example 3, respectively.

[FIG. 5] (A) and (B) of FIG. 5 are conceptual diagrams of compound semiconductor layers and the like for explaining a method of manufacturing a multi-junction solar cell, a compound semiconductor device, a photoelectric conversion device, or a compound-semiconductor-layer lamination structure in Example 4.

[FIG. 6] (A) and (B) of FIG. 6 are conceptual diagrams of the compound semiconductor layers and the like for explaining the method of manufacturing the multi-junction solar cell, the compound semiconductor device, the photoelectric conversion device, or the compound-semiconductor-layer lamination structure in Example 4, following (B) of FIG. 5.

[FIG. 7] FIG. 7 is a conceptual diagram of the compound semiconductor layers and the like for explaining the method of manufacturing the multi-junction solar cell, the compound semiconductor device, the photoelectric conversion device, or the compound-semiconductor-layer lamination structure in Example 4, following (B) of FIG. 6.

[FIG. 8] (A) and (B) of FIG. 8 are conceptual diagrams of compound semiconductor layers and the like for explaining a method of manufacturing a multi-junction solar cell, a compound semiconductor device, a photoelectric conversion device, or a compound-semiconductor-layer lamination structure in Example 5.

[FIG. 9] (A) and (B) of FIG. 9 are conceptual diagrams of the compound semiconductor layers and the like for explaining the method of manufacturing the multi-junction solar cell, the compound semiconductor device, the photoelectric conversion device, or the compound-semiconductor-layer lamination structure in Example 5, following (B) of FIG. 8.

[FIG. 10] (A) and (B) of FIG. 10 are conceptual diagrams of the compound semiconductor layers and the like for explaining the method of manufacturing the multi-junction solar cell, the compound semiconductor device, the photoelectric conversion device, or the compound-semiconductor-layer lamination structure in Example 5, following (B) of FIG. 9.

[FIG. 11] FIG. 11 is a schematic cross-sectional view of a compound semiconductor device, a photoelectric conversion device, and a compound-semiconductor-layer lamination structure in Example 6.

[FIG. 12] FIG. 12 is a schematic cross-sectional view of a compound semiconductor device, a photoelectric conversion device, and a compound-semiconductor-layer lamination structure in Example 7.

[FIG. 13] (A) and (B) of FIG. 13 are conceptual diagrams of a compound semiconductor device, a photoelectric conversion device, or a compound-semiconductor-layer lamination structure in Example 8.

[FIG. 14] FIG. 14 is a conceptual diagram of a modification of the multi-junction solar cell, the compound semiconductor device, the photoelectric conversion device, or the compound-semiconductor-layer lamination structure in Example 1.

[FIG. 15] FIG. 15 is a characteristic diagram illustrating film-forming characteristics of metal atoms.

[FIG. 16] FIG. 16 is a characteristic diagram illustrating a relationship between a thickness of a Ti layer and light transmittance.

[FIG. 17] (A) and (B) of FIG. 17 are photographs showing a result of an infrared microscopic transmission experiment.

[FIG. 18] FIG. 18 is a graph showing a relationship between photon energy and an absorption coefficient in each concentration of a p-type dopant in a p-type GaAs layer.

[FIG. 19] FIG. 19 is a graph showing a relationship between a thickness of the p-type GaAs layer at p-type dopant concentration of $3 \times 10^{19}$ and transmittance of solar light at maximum wavelength of 2.5 $\mu$m.

[FIG. 20] FIG. 20 is a photograph of a bright-field image, of an interface of a junction of an InP substrate and a GaAs substrate, obtained by a scanning transmission electron microscope.

[FIG. 21] FIG. 21 is a graph showing variation in the thickness of the Ti layer and the light transmittance over time.

[FIG. 22] FIG. 22 is a graph showing variation in the thickness of the Ti layer and the light transmittance over time.

[FIG. 23] FIG. 23 is a graph showing a result of quantitative analysis of concentration of each atom in each distance in a lamination direction of the multi-junction solar cell in Example 1 based on energy dispersive X-ray spectrometry.

[FIG. 24] FIG. 24 is a photograph of a cross-section of a bonding junction interface obtained by a transmission electron microscope.

## MODES FOR CARRYING OUT THE INVENTION

The present disclosure will be described below based on Examples referring to the drawings. However, the present disclosure is not limited to the Examples, and various numerical values, materials, etc. in the Examples are examples. It is to be noted that the description will be given in the following order.

1. Description related to general matters of a multi-junction solar cell, a compound semiconductor device, a photoelectric conversion device, and a compound-semiconductor-layer lamination structure of the present disclosure
2. Example 1 (the multi-junction solar cell, the compound semiconductor device, the photoelectric conversion device, and the compound-semiconductor-layer lamination structure of the present disclosure)
3. Example 2 (a modification of Example 1)
4. Example 3 (another modification of Example 1)
5. Example 4 (another modification of Example 1)
6. Example 5 (a modification of Example 4)
7. Example 6 (still another modification of Example 1)
8. Example 7 (a modification of Example 6)
9. Example 8 (another modification of Example 6) and others

[Description related to general matters of a multi-junction solar cell, a compound semiconductor device, a photoelectric conversion device, and a compound-semiconductor-layer lamination structure of the present disclosure]

In a multi-junction solar cell, a compound semiconductor device, a photoelectric conversion device, or a compound-semiconductor-layer lamination structure of the present disclosure (hereinafter, may be collectively and simply referred to as "multi-junction solar cell and the like of the present disclosure" in some cases), depending on lattice constants of compound semiconductors that configure adjacent sub-cells or adjacent compound semiconductor layers (hereinafter, the sub-cells or the compound semiconductor layers may be collectively referred to as "sub-cells and the like" in some cases), the adjacent sub-cells and the like may be of a lattice-matched type or a lattice-mismatched type. However, as a whole, these lattice-matched type/ lattice-mismatched type exist in a mixed manner. Here, in the multi-junction solar cell and the like of the present disclosure, a connection layer may be preferably provided between these adjacent sub-cells and the like when the adjacent sub-cells and the like are of the lattice-mismatched type. In the multi-junction solar cell and the like of the present disclosure, the lattice-mismatched type refers to a type in which misfit dislocation occurs when a compound semiconductor layer is epitaxially grown on a certain compound semiconductor, and when the epitaxially-grown compound semiconductor layer has a thickness over a critical film thickness. It is to be noted that, in the multi-junction solar cell and the like of the present disclosure, where a lattice constant of a compound semiconductor that configures one sub-cell and the like that are adjacent to the connection layer is $Lc_1$, and a lattice constant of a compound semiconductor that configures the other sub-cell and the like that are adjacent to the connection layer is $Lc_2$, being the lattice-mismatched type means, for example, being a type that satisfies:

$$(Lc_1-Lc_2)/Lc_1 \geq 1 \times 10^{-3} \qquad (A)$$

or

$$(Lc_1-Lc_2)/Lc_1 \leq -1 \times 10^{-3} \qquad (B)$$

It is to be noted that, when a value of $(Lc_1-Lc_2)/Lc_1$ is out of the above-described range, that is, when the value satisfies:

$$-1 \times 10^{-3} < (Lc_1-Lc_2)/Lc_1 < 1 \times 10^{-3} \qquad (C),$$

it is the lattice-matched type. However, Expression (A), Expression (B), and Expression (C) are only examples. Further, in the multi-junction solar cell and the like of the present disclosure including such a preferable mode, it may be preferable to achieve a form in which a tunnel junction layer is provided in a place between the adjacent sub-cells and the like in which the connection layer is not provided.

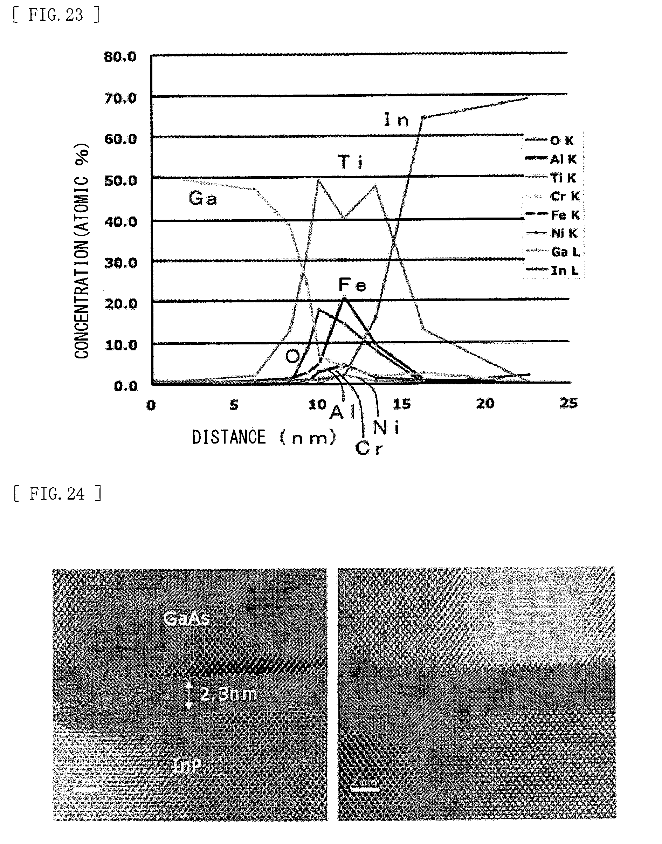

Here, as described above, the connection layer is a layer having amorphous characteristics, and is configured of metal or alloy. Specifically, as a material configuring the connection layer, it may be preferable to use a material having ohmic characteristics with respect to the compound semiconductor layer to be connected, more specifically, metal or alloy having a work function that is smaller than a Fermi level of an n-type semiconductor or is larger than a Fermi level of a p-type semiconductor. Accordingly, contact resistance is significantly reduced, and favorable ohmic connection is achievable. It is to be noted that "amorphous connection layer" or "connection layer having amorphous characteristics" means a state that does not have long-term orderly characteristics as in crystal and that does not allow a lattice image to be observed in an image taken by a transmission electron microscope as shown in FIG. 24.

A metal thin film (having a thickness of several nanometers or less, for example) is typically formed based on a PVD method such as a vacuum evaporation method and a sputtering method. However, at that time, the metal thin film is often formed in an island-like shape and is rarely formed in a layer-like shape. Further, when the metal thin film is formed in an island-like shape, it is difficult to control the film thickness with high accuracy. In formation of a metal thin film based on the vacuum evaporation method, often, an island is formed after atoms and molecules absorbed on a base have undergone processes such as surface diffusion, collision and aggregation, and desorption, and the island grows to be combined with an adjacent island, thereby forming a continuous thin film. At that time, formation of an island, transition from being amorphous to being a crystal layer, variation in crystal alignment, etc. occur.

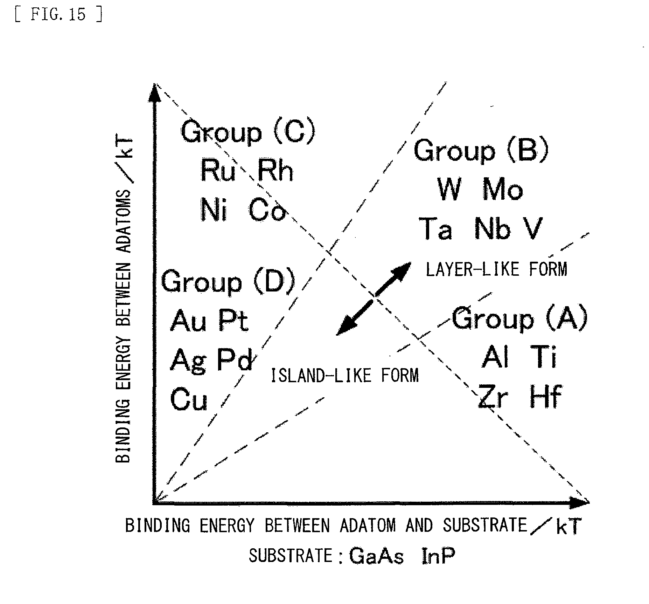

Moreover, when evaporation is performed in a case where the thickness of the metal thin film is set to about that of a monoatomic layer, it is considered that whether metal atoms have a two-dimensional layer structure or a three-dimensional island structure depends on interaction of binding energy between metal atoms in an uppermost face and metal atoms existing therebelow, and binding energy between the metal atoms and the base. When the metal atoms are more stable to be combined to the metal atoms, the metal atoms have the three-dimensional island structure. On the other hand, when the metal atoms are more stable to be combined with the base, the metal atoms have the two-dimensional layer structure. FIG. 15 illustrates analogized characteristics of binding energy between metal atoms and metal atoms for the respective metal atoms [binding energy between adatoms] and analogized characteristics of binding energy between metal atoms and the base (here, GaAs or InP) [binding energy between adatom and substrate]. Metal atoms in Group (A) and Group (B) located in an upper region of a dashed line in FIG. 15 have high binding energy with respect to the base, and therefore, it is considered that the metal atoms are allowed to have the two-dimensional layer structure. Accordingly, as the material of the connection layer, it may be preferable to use the metal atoms belonging to Group (A) or Group (B).

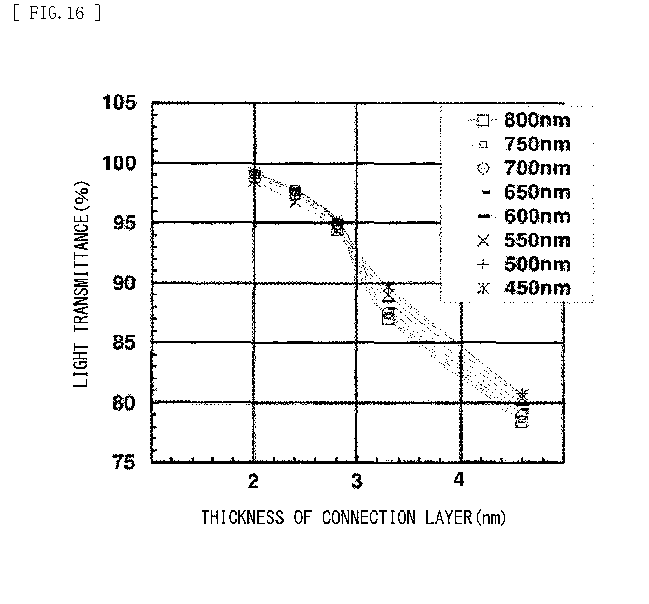

Therefore, it may be preferable to achieve a form in which the connection layer made of an electrically-conductive material, more specifically, the connection layer configured of metal or alloy includes at least one type of atom (metal atom) selected from a group consisting of titanium (Ti), aluminum (Al), zirconium (Zr), hafnium (Hf), tungsten (W), tantalum (Ta), molybdenum (Mo), niobium (Nb), and vanadium (V). It is to be noted that, also when atom such as iron (Fe), chromium (Cr), nickel (Ni), and aluminum (Al) is further included in the connection layer, the characteristics thereof is not influenced at all. Further, in this case, a thickness of the amorphous connection layer may be desirably 5 nm or less, and may be preferably 2 nm or less. FIG. 16 shows a result of measuring a relationship between the thickness of the Ti layer and transmission characteristics of light having wavelengths within a range from 450 nm to 800 nm both inclusive, for example, and it can be seen therefrom that light transmittance of about 80% is secured when the thickness is 5 nm or less. Further, by allowing the thickness to be preferably 2 nm or less, light transmittance of 95% or higher is secured. Alternatively, it may be preferable to achieve a form in which the connection layer is configured of a material selected from a group consisting of aluminum-oxide-doped zinc oxide [AZO], indium-zinc composite oxide [IZO], gallium-doped zinc oxide [GZO], indium-gallium composite oxide [IGO], $In-GaZnO_4$ [IGZO], and indium-tin composite oxide [ITO], that is, a material that is transparent and has electric conductivity. Alternatively, it is possible to achieve a form in which the connection layer is made of an amorphous compound semiconductor, specifically, portion (to be noted, this is amorphous) of a compound semiconductor layer in an interface of a compound semiconductor layer and a compound semiconductor layer. In such a form, the issue of lattice mismatch is avoidable by providing the portion of the amorphous compound semiconductor layer in between, and occurrence of faults such as dislocation is avoidable. Here, the thickness of the amorphous connection layer configured of the above-described materials that is transparent and has electric conductivity, or the thickness of the amorphous connection layer configured of an amorphous compound semiconductor may be desirably $1 \times 10^{-7}$ or less. It is to be noted that the connection layer may be configured, for example, of the above-described metal atoms, and thereby, contact resistance is sufficiently reduced, specifically, the contact resistance is allowed to satisfy $\rho_c \leq 1 \times 10^{-3}$ $\Omega \cdot cm^2$. More specifically, for example, when the connection layer is configured of titanium (Ti), for example, contact resistance $\rho_c$ with respect to a $p^+$-GaAs layer and an $n^+$-InP layer, or with respect to a $p^+$-GaAs layer and an $n^+$-InGaAsP layer is allowed to be $1 \times 10^{-3}$ $\Omega \cdot cm^2$ or smaller.

When the connection layer is configured of the above-described metal atom, in two sub-cells that face each other with the connection layer in between (one sub-cell is referred to as "sub-cell-A" for the sake of convenience, and the other sub-cell is referred to as "sub-cell-B" for the sake of convenience), it may be preferable that a first connection layer is provided in the sub-cell-A, a second connection layer is provided in the sub-cell-B, the first connection layer is joined to the second connection layer to be integrated, and thereby the sub-cell-A is joined to the sub-cell-B. In this case, the metal atom configuring the sub-cell-A and the metal atom configuring the sub-cell-B may be the same, or may be different. A thickness of the first connection layer and a thickness of the second connection layer may be the same, or may be different. It is to be noted that, for example, also when metal or alloy having a work function that is larger than the Fermi level of the n-type semiconductor or is smaller than the Fermi level of the p-type semiconductor is used, if the connection layer is configured, for example, of the first connection layer and the second connection layer having the same thickness, a width of each depletion layer is 1/2 of that of the pn junction. Accordingly, probability of causing a tunneling effect is increased. Therefore, it is an advantageous structure in terms of reduction in contact resistance. It may be desirable to perform plasma treatment on a junction face of the first connection layer and a junction face of the second connection layer before joining the first connection layer to the second connection layer, and thereby, to activate the junction face of the first connection layer and the junction face of the second connection layer. In other words, a dangling bond may be desirably formed in the junction interface. Also, by performing the plasma treatment, the first connection layer and the second connection layer are allowed to be amorphous. The junction of the first connection layer and the second connection layer is allowed to be performed at an ambient pressure of $5 \times 10^{-4}$ Pa or lower, with a junction load of $2 \times 10^4$ or less, and at a temperature of 150°C or lower. It may be desirable to perform the plasma treatment and the junction of the first connection layer and the second connection layer without breaking a vacuum in terms of prevention of oxidation of the junction face of the first connection layer and the junction face of the second connection layer. The same is applicable also to the compound semiconductor device, the photoelectric conversion device, or the compound-semiconductor-layer lamination structure of the present disclosure.

Moreover, in the multi-junction solar cell of the present disclosure including the above-described preferable form or configuration, it may be preferable to achieve a form in which conductivity types of the compound semiconductor layers that face each other in the sub-cells adjacent to each other are different. In particular, where the sub-cells adjacent to each other are "sub-cell-a" and "sub-cell-b", a compound semiconductor layer, in the sub-cell-a, that faces the sub-cell-b is "compound semiconductor layer-a", and a compound semiconductor layer, in the sub-cell-b, that faces the sub-cell-a is "compound semiconductor layer-b", it may be preferable to achieve a form in which a conductivity type of the compound semiconductor layer-a is different from a conductivity type of the compound semiconductor layer-b. Further, in the compound semiconductor device of the present disclosure, it may be preferable to achieve a form in which conductivity types of the compound semiconductor layers that face each other with the connection layer in between are different. The same is applicable also to the photoelectric conversion device or the compound-semiconductor-layer lamination structure of the present disclosure.

Moreover, in the multi-junction solar cell and the like of the present disclosure including the above-described preferable form or configuration, it may be desirable to achieve a form in which a thickness of a compound semiconductor layer having the conductivity type of the p-type out of the compound semiconductor layers configuring the sub-cells and the like, more specifically, a thickness of the $p^+$-GaAs layer is 100 nm or less.

Moreover, in the multi-junction solar cell and the like of the present disclosure including the above-described preferable form or configuration, as the sub-cell or the compound semiconductor layer, an InGaAs layer, an InGaAsP layer, a GaAs layer, an InGaP layer, an AlInGaP layer, a GaAsN layer, an InGaAsN layer, an InP layer, an InAlAs layer, an InAlAsSb layer, an InGaAlAs layer, and an AlGaAs layer can be mentioned. However, in particular, it may be preferable to achieve a form in which the sub-cells or the compound semiconductor layers are configured of GaAs or InP. A lamination order in the sub-cell is set to be a lamination order by which a band gap of the compound semiconductor configuring the sub-cell becomes larger as the compound semiconductor is closer to a light incident side, that is, a lamination order by which the band gaps of the compound semiconductors are larger in order from a support substrate side to a second electrode side which will be described later. In some cases, part of the plurality of sub-cells may be configured of a Ge layer.

More specifically, when the multi-junction solar cell of the present disclosure including the above-described preferable form or configuration is configured of two sub-cells, the respective sub-cells may be configured, for example, of the followings.

(InGaAsP layer, InGaAs layer)
(InGaAs layer, InGaAs layer)
(InP layer, InGaAs layer)
(AlGaAs layer, InGaAsP layer)
(AlGaAs layer, InGaAs layer)

It is to be noted that light enters from the sub-cell having a layer configuration described on the most-left side in ( ). Further, when three sub-cells are used, the respective sub-cells may be configured, for example, of the followings,

(GaAs layer, InGaAsP layer, InGaAs layer)
(InGaAs layer, InGaAsP layer, InGaAs layer)
(InGaP layer, InGaAs layer, InGaAs layer).

Further, when four sub-cells are used, the respective sub-cells may be configured, for example, of the followings.

(GaInP layer, GaAs layer, InGaAsP layer, InGaAs layer)
(GaInP layer, InGaAs layer, InGaAsP layer, InGaAs layer)
(GaInP layer, InGaAs layer, InGaAsN layer, InGaAs layer)

Further, when five sub-cells are used, the respective sub-cells may be configured, for example, of the followings.

(GaInP layer, GaAs layer, InGaAs layer, InGaAsP layer, InGaAs layer)
(GaInP layer, GaAs layer, InGaAsN layer, InGaAsP layer, InGaAs layer)
(GaInP layer, GaAs layer, InGaAs layer, InGaAs layer, InGaAs layer)

Further, when six sub-cells are used, the respective sub-cells may be configured, for example, of the following.

(AlGaInP, GaInP, AlGaInAs, GaAs, InGaAs, InGaAs)

The same is applicable also to the compound semiconductor device, the photoelectric conversion device, or the compound-semiconductor-layer lamination structure of the present disclosure. It is to be noted that, when a plurality of sub-cells are described to be configured of the same compound semiconductor in one multi-junction solar cell, composition ratios thereof are different.

The multi-junction solar cell, the compound semiconductor device, the photoelectric conversion device, or the compound-semiconductor-layer lamination structure of the present disclosure including the above-described preferable form or configuration is provided on a substrate. A substrate for film formation that is used at the time of manufacturing the multi-junction solar cell and the like of the present disclosure and a support substrate that is used for assembling the multi-junction solar cell and the like of the present disclosure may be the same substrate, or may be different substrates. It is to be noted that a substrate (corresponding to the base) in a case where the substrate for film formation is the same as the support substrate is expressed as "substrate for film-formation/support" for the sake of convenience. Alternatively, when the substrate for film formation is different from the support substrate, the respective substrates are expressed as "substrate for film formation" and "support substrate". In this case, after the compound semiconductor layers and the like are formed on the substrate for film formation (corresponding to the base), the substrate for film formation may be removed from the compound semiconductor layers and the like, and the compound semiconductor layers and the like may be fixed to the support substrate, or may be bonded to the support substrate. As a method of removing the substrate for film formation from the compound semiconductor layers and the like, a laser ablation method, a heating method, an etching method, etc. can be mentioned. Further, as a method of fixing or bonding the compound semiconductor layers and the like to the support substrate, a metal junction method, a semiconductor junction method, and a metal-semiconductor junction method may be mentioned other than a method using a bonding agent.

As the substrate for film-formation/support, for example, an InP substrate may be mentioned.

Moreover, as the substrate for film formation, a substrate made of a III-V group semiconductor or a II-VI group semiconductor can be mentioned. Specifically, as the substrate made of the III-V group semiconductor, GaAs, InP, GaN, AlN, etc. can be mentioned, and as the substrate made of the II-VI group semiconductor, CdS, CdTe, ZnSe, ZnS, etc. can be mentioned. Further, a substrate made of a I-III-VI group semiconductor called a chalcopyrite type made of Cu, In, Ga, Al, Se, S, etc. may be used, and specifically, $Cu(In,Ga)Se_2$ abbreviated as CIGS, $Cu(In,Ga)(Se,S)_2$ abbreviated as CIGSS, $CuInS_2$ abbreviated as CIS, etc. can be mentioned.

Moreover, as the support substrate, other than the above-described various substrates, a glass substrate, a quartz substrate, a transparent inorganic substrate such as a sapphire substrate, and a transparent plastic substrate or film made of a material such as: polyester resin such as polyethylene terephthalate (PET) and polyethylene naphthalate (PEN); polycarbonate (PC) resin; polyether sulfone (PES) resin; polyolefin resin such as polystyrene, polyethylene, and polypropylene; polyphenylene sulfide resin; polyvinylidene difluoride resin; tetraacetyl cellulose resin; phenoxy bromide resin; aramid resin; polyimide resin; polystyrene resin; polyarylate resin; polysulfone resin; acrylic resin: epoxy resin; fluororesin; silicone resin; diacetate resin; triacetate resin; polyvinyl chloride resin; and cyclic polyolefin resin can be mentioned. As the glass substrate, for example, a soda glass substrate, a heat-resistance glass substrate, and a quartz glass substrate can be mentioned.

A second electrode is formed on a sub-cell in an upper-most layer in the sub-cells configuring the multi-junction solar cell of the present disclosure. The second electrode may preferably have a thickness, for example, of about 10 nm to 100 nm both inclusive, and may be preferably configured of a material having favorable light transmission characteristics and having a small work function. As such a material, for example, indium-tine oxide (including ITO, Indium Tin Oxide, Sn-doped $In_2O_3$, crystalline ITO, and amorphous ITO), indium-zinc oxide (IZO, Indium Zinc Oxide), IFO (F-doped $In_2O_3$), tin oxide ($SnO_2$), ATO (Sb-doped $SnO_2$), FTO (F-doped $SnO_2$), zinc oxide (including ZnO, Al-doped ZnO, and B-doped ZnO), InSnZnO, spinel-type oxides, oxides having a $YbFe_2O_4$ structure, etc. can be mentioned. Further, alkaline-earth metal such as calcium (Ca) and barium (Ba), alkali metal such as lithium (Li) and cesium (Cs), indium (In), magnesium (Mg), silver (Ag), gold (Au), nickel (Ni), gold-germanium (Au-Ge), etc. can also be mentioned. Further, alkali-metal oxide such as $Li_2O$, $Cs_2Co_3$, $Cs_2SO_4$, MgF, LiF, and $CaF_2$, alkali-metal fluoride, alkaline-earth-metal oxide, and alkaline-earth fluoride can also be mentioned. The second electrode may have a single-layer configuration, or may have a configuration made by laminating a plurality of layers. The second electrode is allowed to be formed by a physical vapor deposition method (a PVD method) such as a vacuum evaporation method and a sputtering method, a chemical vapor deposition method (a CVD method), etc. The same is applicable also to the compound semiconductor device, the photoelectric conversion device, or the compound-semiconductor-layer lamination structure of the present disclosure.

The first electrode is formed on the sub-cells, the compound semiconductor layers, etc. Alternatively, depending on materials configuring the substrate for film-formation/support or the support substrate, the substrate for film-formation/support or the support substrate itself may be used as the first electrode. As a material configuring the first electrode, molybdenum (Mo), tungsten (W), tantalum (Ta), vanadium (V), palladium (Pd), zinc (Zn), nickel (Ni), titanium (Ti), platinum (Pt), and gold-zinc (Au-Zn) can be mentioned as examples.

An anti-reflection film may be preferably formed on a portion, on the sub-cell in the uppermost layer (the sub-cell on the light incident side) in the sub-cells configuring the multi-junction solar cell of the present disclosure, on which the second electrode is not formed. The anti-reflection film is provided in order to suppress reflection in the sub-cell in the uppermost layer, and to take in solar light efficiently in the multi-junction solar cell of the present disclosure. As a material configuring the anti-reflection film, a material having a refractive index that is smaller than that of the compound semiconductor configuring the sub-cell in the uppermost layer may be preferably used. Specifically, for example, a layer made of $TiO_2$, $Al_2O_3$, ZnS, $MgF_2$, $Ta_2O_5$, $SiO_2$, or $Si_3N_4$, or a lamination structure of these layers can be mentioned. As a thickness of the anti-reflection film, for example, from 10 nm to 200 nm both inclusive can be mentioned. The same is applicable also to the compound semiconductor device, the photoelectric conversion device, or the compound-semiconductor-layer lamination structure of the present disclosure.

EXAMPLE 1

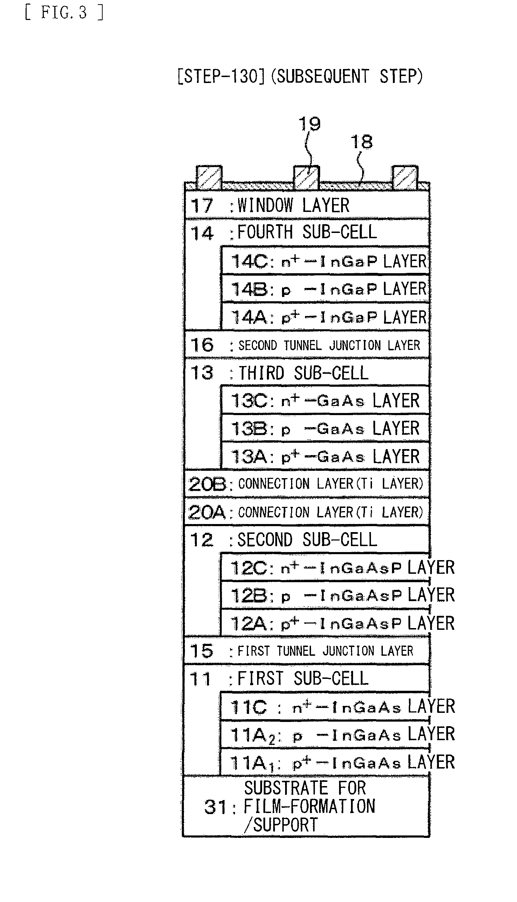

Example 1 relates to the multi-junction solar cell, the compound semiconductor device, the photoelectric conversion device, and the compound-semiconductor-layer lamination structure of the present disclosure. FIG. 3 illustrates a conceptual diagram of the multi-junction solar cell, the compound semiconductor device, the photoelectric conversion device, and the compound-semiconductor-layer lamination structure in Example 1.

The multi-function solar cell in Example 1 is configured by laminating a plurality of (four, in Example 1) sub-cells (a first sub-cell 11, a second sub-cell 12, a third sub-cell 13, and a fourth sub-cell 14). It is to be noted that the first sub-cell 11, the second sub-cell 12, the third sub-cell 13, and the fourth sub-cell 14 are formed in order on a support substrate 31 (also serving as the substrate for film formation), and for example, solar light may enter from the fourth sub-cell 14. Further, each of the sub-cells 11, 12, 13, and 14 is configured by laminating a plurality of a plurality of compound semiconductor layers. Specifically, each of the sub-cells 11, 12, 13, and 14 is configured by laminating a compound semiconductor layer of a first conductivity type and a compound semiconductor layer of a second conductivity type. It is to be noted that a lamination order of the plurality of sub-cells is set to be a lamination order by which a band gap of the compound semiconductor configuring the sub-cell becomes larger as the compound semiconductor is closer to a light incident side, that is, a lamination order by which the band gaps of the compound semiconductors are larger in order from a substrate for film-formation/support side to the second electrode side. Moreover, in the description below, the first conductivity type is set as a p-type, and the second conductivity type is set as an n-type. Further, the base, the substrate for film-formation/support, and the substrate for film formation are each configured of a p-type InP substrate. However, the present disclosure is not limited thereto. The first conductivity type may be the n-type, the second conductivity type may be the p-type, and the base, the substrate for film-formation/support, and the substrate for film formation may each be an n-type InP substrate.

Moreover, an amorphous connection layer 20 (connection layers 20A and 20B) made of an electrically-conductive material is provided in at least one place between the adjacent sub-cells, that is, between the second sub-cell 12 and the third sub-cell 13 that are of the lattice-mismatched type in Example 1. Here, the connection layer 20 is made of titanium (Ti) having a thickness of 1.0 nm. It is to be noted that the connection layer 20 has the two-dimensional layer structure and does not have the three-dimensional island structure.

The compound semiconductor device, the photoelectric conversion device, or the compound-semiconductor-layer lamination structure in Example 1 is configured by laminating a plurality of a plurality of compound semiconductor layers (11A, 11B, 11C, 12A, 12B, 12C, 13A, 13B, 13C, 14A, 14B, and 14C), and in at least one place between the adjacent compound semiconductor layers (specifically, between the compound semiconductor layer 12C and the compound semiconductor layer 13A), the amorphous connection layer 20 made of the electrically-conductive material is provided.

A configuration of each of the sub-cells 11, 12, 13, and 14 is shown in Table 1 below. It is to be noted that, in Table 1, concerning the compound semiconductor layers configuring each sub-cell, a compound semiconductor layer closer to the support substrate is described on a lower side, and a compound semiconductor layer farther from the support substrate is described on an upper side.

[Table 1]

Fourth sub-cell 14: Band gap 1.90 eV, Lattice constant 5.653 Å
Compound semiconductor layer 14C: $n^+$-$In_{0.48}Ga_{0.52}P$
Compound semiconductor layer 14B: p-$In_{0.48}Ga_{0.52}$
Compound semiconductor layer 14A: $p^+$-$In_{0.48}Ga_{0.52}$
Third sub-cell 13: Band gap 1.42 eV, Lattice constant 5.653 Å
Compound semiconductor layer 13C: $n^+$-GaAs
Compound semiconductor layer 13B: p-GaAs
Compound semiconductor layer 13A: $p^+$-GaAs
Second sub-cell 12: Band gap 1.02 eV, Lattice constant 5.868 Å
Compound semiconductor layer 12C: $n^+$-$In_{0.79}Ga_{0.21}As_{0.43}P_{0.57}$
Compound semiconductor layer 12B: p-$In_{0.79}Ga_{0.21}As_{0.43}P_{0.57}$

(continued)

Compound semiconductor layer 12A: $p^+$-$In_{0.79}Ga_{0.21}As_{0.43}P_{0.57}$
First sub-cell 11: Band gap 0.75 eV, Lattice constant 5.868 Å
Compound semiconductor layer 11C: $n^+$-$In_{0.53}Ga_{0.47}As$
Compound semiconductor layer 11B: p-$In_{0.53}Ga_{0.47}As$
Compound semiconductor layer 11 A: $p^+$-$In_{0.53}Ga_{0.47}As$

Moreover, in the multi-function solar cell in Example 1, for example, a second electrode 19 made of a lamination structure of AuGe/Ni/Au having thicknesses of 150 nm/50 nm/500 nm is formed on the fourth sub-cell 14, and an anti-reflection film 18 made of a $TiO_2$ film and an $Al_2O_3$ film is formed on a portion, on the fourth sub-cell 14, on which the second electrode 19 is not formed. It is to be noted that, in the drawings, the second electrode 19 and the anti-reflection film 18 are each illustrated as one layer. The substrate for film-formation/support 31 is configured of a p-type InP substrate. Further, a first tunnel junction layer 15 configured of $p^+$-InGaAs (upper layer)/$n^+$-InGaAs (lower layer) is provided between the first sub-cell 11 and the second sub-cell 12 that are of the lattice-matched type, and a second tunnel junction layer 16 configured of $p^+$-InGaP (upper layer)/$n^+$-InGaP (lower layer) is provided between the third sub-cell 13 and the fourth sub-cell 14 that are of the lattice-matched type. Further, a window layer 17 configured of $n^+$-AlInP is formed between the fourth sub-cell 14, and the second electrode 19 and the anti-reflection film 18. It is to be noted that the window layer 17 is provided in order to prevent recombination of carriers in the uppermost surface, but may not be necessarily provided. The first electrode is connected to the first sub-cell 11; however, illustration of the first electrode is omitted.

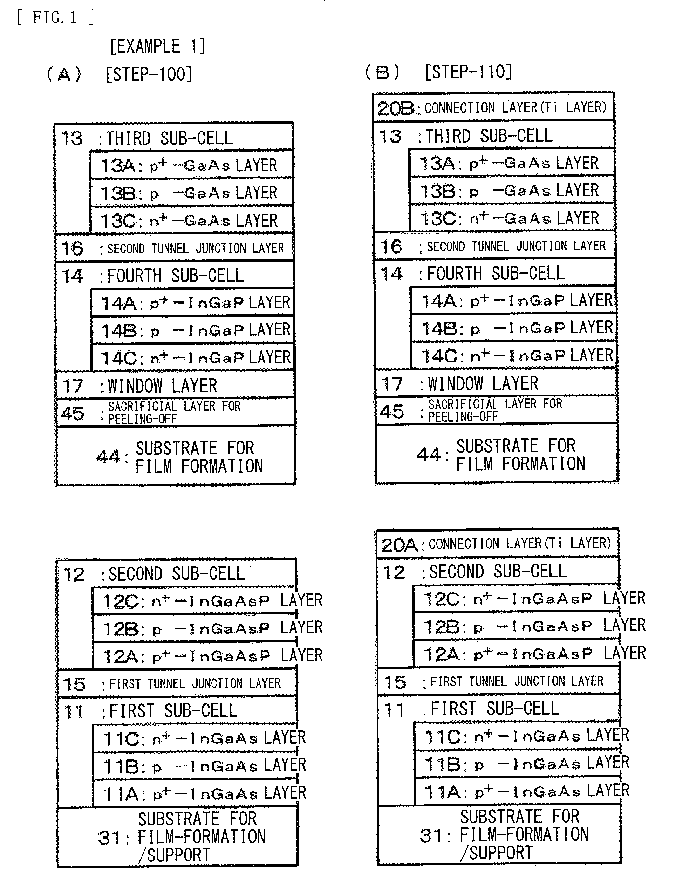

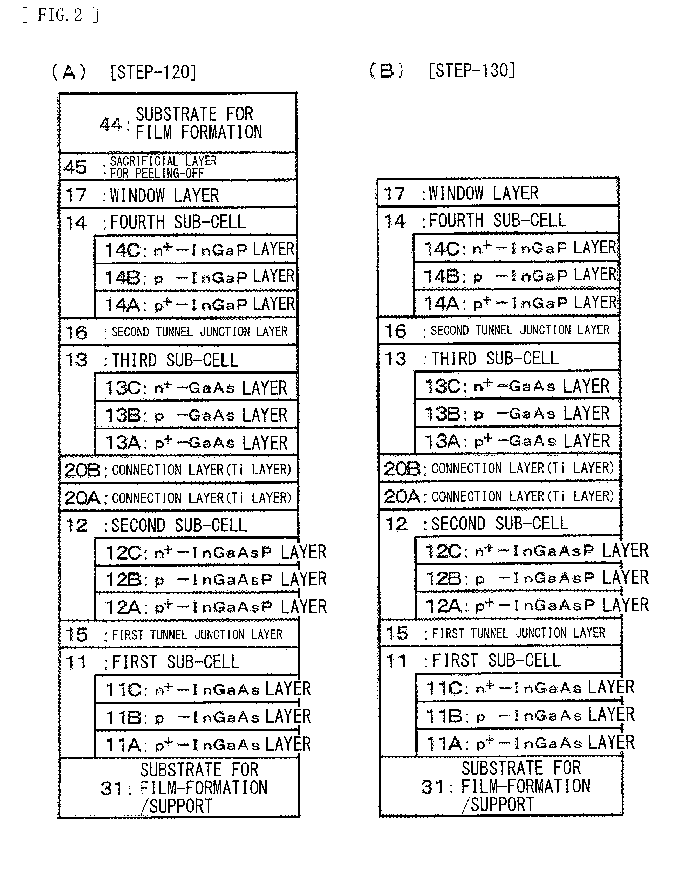

Description will be given below of a method of manufacturing the multi-junction solar cell and the like in Example 1 referring to (A) to (B) of FIG.1, (A) to (B) of FIG. 2, and FIG. 3 that are conceptual diagrams of the compound semiconductor layers and the like.

[Step-100]

On the substrate for film-formation/support 31 configured of the p-type InP substrate, the first sub-cell 11 (the compound semiconductor layers 11A to 11C), the first tunnel junction layer 15, and the second sub-cell 12 (the compound semiconductor layer 12A to 12C) that are of the lattice-matched type are epitaxially grown in a sequential manner based on an MOCVD method. On the other hand, on the substrate for film formation 44 configured of the n-type GaAs substrate, a sacrificial layer for peeling-off 45 configured of AlAs is formed, and then, the window layer 17 configured of $n^+$-AlInP is formed, based on the MOCVD method. Subsequently, on this window layer 17, the fourth sub-cell layer 14 (the compound semiconductor layers 14C to 14A), the second tunnel junction layer 16, and the third sub-cell 13 (the compound semiconductor layers 13C to 13A) that are of the lattice-matched type are epitaxially grown in a sequential manner. Thus, a structure shown in the conceptual diagram in (A) of FIG. 1 is obtained.

Next, the compound semiconductor layer 12C configured of $n^+$-$In_{0.79}Ga_{0.21}As_{0.43}P_{0.57}$ configuring the second compound semiconductor layer 12 is joined to the compound semiconductor layer 13A configured of $p^+$-GaAs configuring the third compound semiconductor layer 13 with the connection layer 20 in between, and thereby, ohmic contact is obtained.

[Step-110]

Specifically, first, the first connection layer 20A is formed on the compound semiconductor layer 12C configuring the second compound semiconductor layer 12, and the second connection layer 20B is formed on the compound semiconductor layer 13A configuring the third compound semiconductor layer 13 (see (B) of FIG. 1). More specifically, for example, the connection layers 20A and 20B each configured of Ti with a thickness of 0.5 nm may be formed on each of the compound semiconductor layer 12C and the compound semiconductor layer 13A based on a vacuum evaporation method (under conditions of: at a vacuum degree of $2 \times 10^{-4}$ Pa; at evaporation speed of 0.1 nm/sec or lower; and at a temperature from 150°C to 200°C both inclusive). It is to be noted that, in this case, for example, a resistance heating scheme may be adopted setting a substrate temperature at 80°C and a substrate rotation speed at 30 rpm. However, the film formation method of the connection layers 20A and 20B is not limited thereto, and, for example, a sputtering method (under conditions of: at film formation speed of 0.1 nm/sec or lower; and at a temperature from 150°C to 200°C both inclusive) may be used.

[Step-120]

Subsequently, after performing plasma treatment on the connection layers 20A and 20B, the second compound semiconductor layer 12 is joined to the third compound semiconductor layer 13. Specifically, argon (Ar) plasma (for example, at plasma density from $10^9$ $cm^{-3}$ to $10^{11}$ $cm^{-3}$ both inclusive, and at a pressure from 1 Pa to $10^{-2}$ Pa both inclusive) is applied to surfaces of the connection layers 20A and 20B, and thereby, the surfaces (junction faces) of the connection layers 20A and 20B are activated. In other words, a dangling bond is formed in the junction interface (the surfaces of the connection layers 20A and 20B). Also, the connection layers 20A and 20B are allowed to be amorphous. Further, the connection layers 20A and 20B are joined (bonded) to each other while maintaining high degree of vacuum, that is, at an ambient pressure of $5 \times 10^{-4}$ Pa or lower, at junction load of $2 \times 10^4$ or less, and at a temperature of 150°C or lower, specifically, for example, at an ambient pressure of $1 \times 10^{-4}$ Pa, at junction load of $2 \times 10^4$ N, and at a temperature of 25°C. Thus, a structure illustrated in the conceptual diagram in (A) of FIG. 2 is obtained. In Example 1, metal (specifically, Ti) is used as the material of the connection layer 20. As described above, at the time of film formation, the metal thin film may be often formed in an island-like form, and a layer-like form is rarely obtained. However, film formation in the layer-like form is possible with the metal atoms in Group (A) and Group (B) shown in FIG. 15.

[Step-130]

Thereafter, the substrate for film formation 44 is peeled off, and the anti-reflection film 18 and the second electrode 19 are formed. Specifically, after the substrate for film formation 44 is peeled off by removing the sacrificial layer for peeling-off 45 is removed by etching (see (B) of FIG. 2), for example, a resist pattern may be formed on the window layer 17 based on a photolithography technique, and the second electrode 19 may be formed by a vacuum evaporation method (at vacuum degree of $2 \times 10^{-4}$ Pa, at evaporation speed of 0.1 nm/sec, and at a temperature from 150°C to 200°C both inclusive). It is to be noted that the substrate for film formation 44 is allowed to be reused. Next, by removing the resist pattern, the second electrode 19 is formed based on a lift-off method. Subsequently, a resist pattern is formed based on a photolithography technique, and, for example, the anti-reflection film 18 configured of a $TiO_2$ film and an $Al_2O_3$ film may be formed by a vacuum evaporation method (at vacuum degree of $2 \times 10^{-4}$ Pa, at evaporation speed of 0.1 nm/sec, and at a temperature from 150°C to 200°C both inclusive). Subsequently, by removing the resist pattern, the anti-reflection film 18 is formed based on a lift-off method. Thus, the multi-junction solar cell illustrated in FIG. 3 is obtained.

The multi-junction solar cell in Example 1 is configured of the plurality of sub-cells. By laminating the plurality of sub-cells configured of compound semiconductors having different band gaps (by achieving multi-junction), solar light that has a wide range of energy distribution is utilized efficiently. Further, in the multi-junction solar cell in Example 1, out of the plurality of sub-cells 11, 12, 13, and 14 configured of compound semiconductor layers having different compositions, at least the sub-cells having different lattice constants (in Example 1, between the second sub-cell 12 and the third sub-cell 13, $(Lc_1-Lc_2)/Lc_1 = 3.8 \times 10^{-2}$) are joined to each other with the connection layer 20 in between. The connection layer 20 is allowed to be formed in a layer-like form as a thin film (for example, of 5 nm or less), and in particular, achieves ohmic resistance with respect to the compound semiconductor layer. Also, by using titanium (Ti) having low resistivity, the contact resistance value of the junction portion is suppressed to $1 \times 10^{-3}$ $\Omega \cdot cm^2$ or smaller.

Usually, in surface activation by plasma application, plasma damage is caused in the junction surface. However, in Example 1, the connection layers 20A and 20B made of metal are formed on the surfaces of the second sub-cell 12 and the third sub-cell 13, then, the surfaces of the connection layers 20A and 20B are activated by plasma application, and thereafter, the connection layers 20A and 20B are joined to each other. Here, the connection layers 20A and 20B serve as protective films with respect to the second sub-cell 12 and the third sub-cell 13, and occurrence of plasma damage in the second sub-cell 12 and the third sub-cell 13 is prevented. Therefore, an increase in contact resistance caused by the plasma application is prevented. It is to be noted that the connection layer 20 configured of Ti formed by the vacuum evaporation method has become a layer having amorphous characteristics because of this plasma application. It is to be noted that conditions for the plasma application are set to conditions that allow collision energy of plasma to be relatively weak. In particular, conditions that cause damage in a region at several-ten nanometers or more from the surface are not used as usual, and conditions that damage a region only at several nanometers from the surface are used.

Moreover, in Example 1, the surfaces of the connection layers 20A and 20B are activated by the plasma application for junction, and therefore, junction is allowed to be formed at a low temperature of 150°C or lower. Accordingly, compound semiconductor materials are allowed to be selected without being limited by thermal expansion coefficients. In other words, degree of freedom in selecting the compound semiconductor materials that configure the multi-junction solar cell is increased, and it becomes possible to select compound semiconductor materials that allow spacings of band gaps to be equal. Further, occurrence of damage in the junction face due to heating is also prevented.

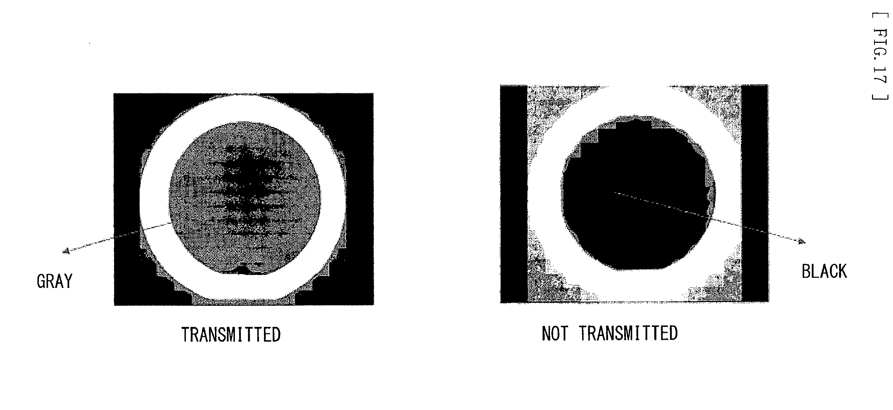

By the way, the amounts of an n-type dopant and a p-type dopant added to the respective compound semiconductor layers are set to allow dopant concentration in the respective $n^+$-type and $p^+$-type compound semiconductor layers to be, for example, about from $1 \times 10^{16}$ $cm^{-3}$ to $5 \times 10^{19}$ $cm^{-3}$ both inclusive. However, when the dopant concentration of the $p^+$-GaAs layer is $1 \times 10^{19}$ $cm^{-3}$ or higher, light having a long wavelength may not be transmitted because of free carrier absorption. (A) and (B) of FIG. 17 show results of infrared microscopic transmission experiments for p+-GaAs layer (dopant concentration: $2\times10^{19}$ cm$^{-3}$)/n+-InP layer (dopant concentration: $4\times10^{18}$ cm$^{-3}$) and n+-GaAs layer (dopant concentration: $2\times10^{18}$ cm$^{-3}$)/n+-InP layer (dopant concentration: $4\times10^{18}$ cm$^{-3}$) at a wavelength from 1.1 μm to 1.2 μm. It can be seen that, when the n+-GaAs layer having low dopant concentration as $2\times10^{18}$ cm$^{-3}$ is used, light is transmitted as shown in (A) of FIG. 17, and on the other hand, when the p+-GaAs layer having high dopant concentration as $2\times10^{19}$ cm$^{-3}$ is used, light is not transmitted as shown in (B) of FIG. 17. Accordingly, it can be found that the p+-GaAs layer having high dopant concentration as $2\times10^{19}$ cm$^{-3}$ is not transparent with respect to light having a long wavelength. Therefore, when the thickness of the p+-GaAs layer is large, the p+-GaAs layer becomes an absorption layer, and therefore, it is necessary to reduce the thickness thereof depending on design. For example, in the p+-GaAs layer having dopant concentration as $2\times10^{19}$ cm$^{-3}$, an absorption coefficient is as large as 2500 cm$^{-1}$ with respect to light having photon energy of 0.5 eV (having a wavelength of about 2.5 μm). Therefore, in order to allow light transmittance to be 90% or higher, the thickness may be preferably 400 nm or less. Moreover, by allowing the thickness to be 40 nm or less, the light transmittance is allowed to be 99% or higher.

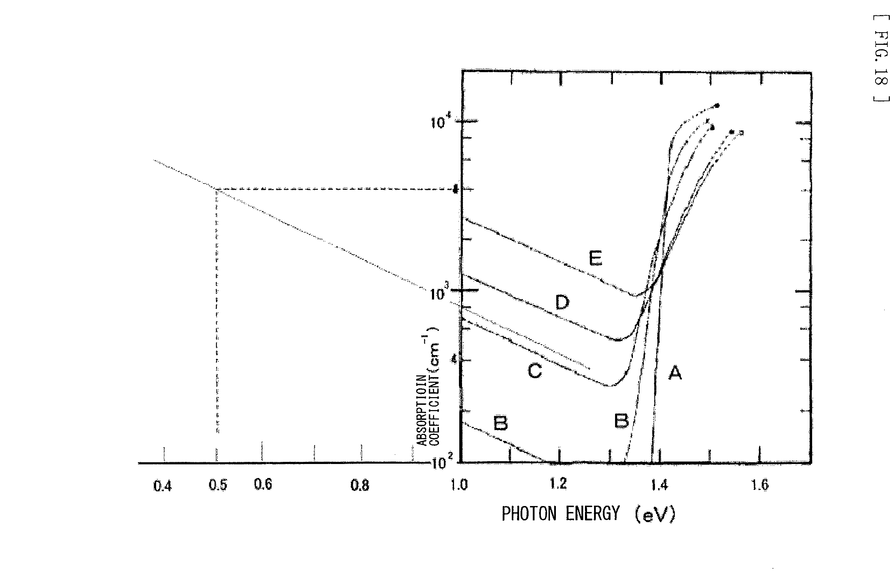

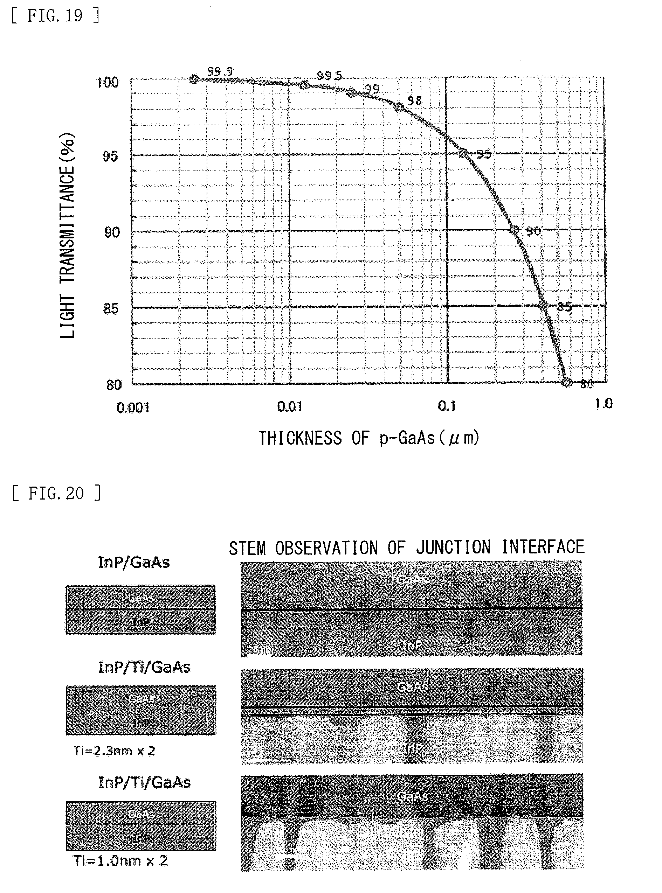

Moreover, in order to improve efficiency in utilizing solar light, it is necessary to take in solar light spectrum in a wide range. The maximum wavelength of the solar light spectrum is 2.5 μm. However, as described above, when the concentration of the p-type dopant is high, light having a long wavelength is difficult to be transmitted. FIG. 18 shows a relationship between photon energy and absorption coefficients for each concentration of the p-type dopant in the p-type GaAs layer. It is to be noted that, in FIG. 18, "A" is data for p-type dopant concentration of $1.5\times10^{17}$, "B" is data for p-type dopant concentration of $1.1\times10^{19}$, "C" is data for p-type dopant concentration of $2.6\times10^{19}$, "D" is data for p-type dopant concentration of $6.0\times10^{19}$, and "E" is data for p-type dopant concentration of $1.0\times10^{20}$. As can be seen from FIG. 18, the p-type GaAs layer having p-type dopant concentration of $3\times10^{19}$ has an absorption coefficient of 4000 cm$^{-1}$ with respect to light having photon energy of 0.5 eV (a wavelength of about 2.5 μm). FIG. 19 shows a relationship between the thickness of the p-type GaAs layer having p-type dopant concentration of $3\times10^{19}$ and light transmittance of solar light having the maximum wavelength of 2.5 μm based on the data in FIG. 18. As can be seen from FIG. 19, in order to obtain light transmittance of solar light of 90% or higher, the thickness of the p-type GaAs layer may be set to 270 nm or less, and in order to obtain light transmittance of 98% or higher, the thickness thereof may be set to 50 nm or less. Further, it is found that, in order to obtain light transmittance of 99% or higher, the thickness thereof may be set to 25 nm or less.

For reference, FIG. 20 shows a photograph of a bright-field image of an interface of the junction of the InP substrate and the GaAs substrate taken by a scanning transmission electron microscope. Here, an upper part of FIG. 20 is an interface obtained by directly joining the InP substrate to the GaAs substrate. Further, a middle part and a lower part of FIG. 20 are interfaces obtained by forming Ti layers having thicknesses of 2.3 nm and 1.0 nm, on the InP substrate and the GaAs substrate, respectively, with the use of an evaporation apparatus of a resistance-heating scheme at vacuum degree of $2\times10^{-4}$ Pa, at evaporation speed of 0.1 nm/sec, at a substrate temperature of 80°C, and at substrate rotation speed of 30 rpm, and then, joining the two substrates to each other with these Ti layers in between. As can be seen from the photographs shown in the middle part and the lower part of FIG. 20, the layer-like Ti layers having substantially uniform thicknesses are formed.

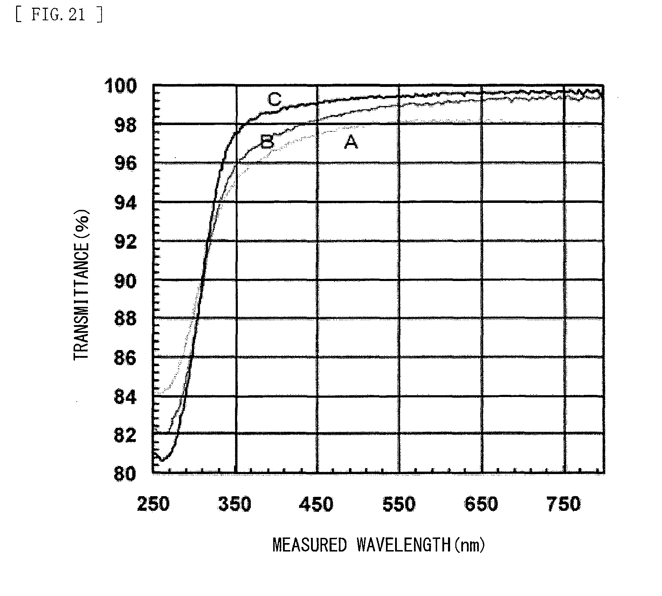

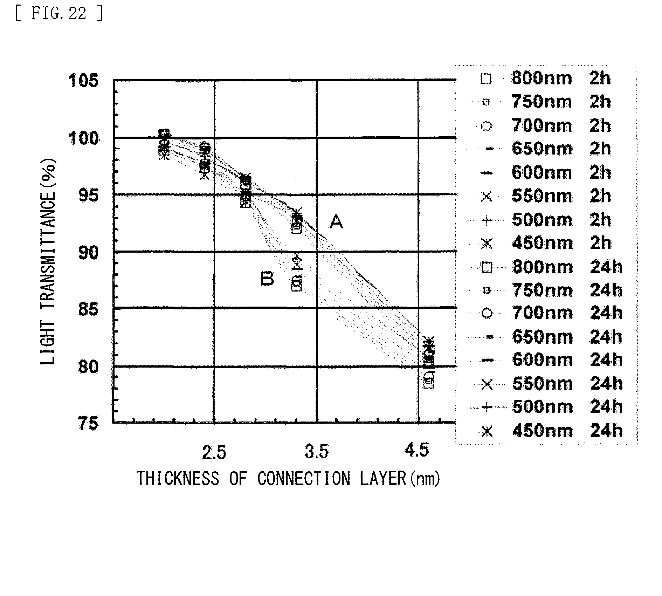

Moreover, for reference, an oxidation state of the Ti layer was examined. Generally, metal is easier to be naturally-oxidized compared to semiconductors. FIG. 21 shows variation in light transmittance over time of the Ti layer having a thickness of 2.0 nm for each wavelength. It is to be noted that, in FIG. 21, "A" is data in a case where the Ti layer is left in atmosphere for 2 hours, "B" is data in a case where the Ti layer is left in atmosphere for 24 hours, and "C" is data in a case where the Ti layer is left in atmosphere for 3 months. Further, FIG. 22 shows light transmittance after 2 hours have elapsed after the film formation (shown as "B" group in FIG. 22), and light transmittance after 24 hours have elapsed after the film formation (shown as "A" group in FIG. 22). As can be seen from FIG. 21 and FIG. 22, light transmittance is increased as the time elapses. In particular, based on FIG. 22, the light transmittance 24 hours after the film formation is increased by from 3% to 6% compared with the light transmittance 2 hours after the film formation. It can be considered that this is because a titanium oxide film (TiO$_2$) is formed on the surface of the Ti film due to exposure to atmosphere, and therefore, the thickness of Ti is reduced. When an oxide film such as TiO$_2$ is formed, contact resistance in the junction interface is increased, and electric conductivity may be lowered.

Moreover, for reference, evaluation was done on plasma treatment (plasma application). The oxide film formed on the surfaces of the connection layers 20A and 20B is removed by the plasma treatment (the plasma application at the same time as the time of activation of the surfaces of the connection layers 20A and 20B). Specifically, energy of ions that are incident on the surfaces of the connection layers 20A and 20B by the Ar plasma treatment is utilized to cut the bonding between the metal atom (Ti atom) and an oxygen atom and to allow the oxygen atom to be separated from the surfaces. FIG. 23 shows a result of quantitative analysis of concentration of each atom in each distance in a lamination direction of the multi-junction solar cell based on an energy dispersive X-ray spectrometry (EDX). A content of oxygen (O) in a region at about 10 nm in which the connection layer 20 is formed is 1/3 or less compared to a content of Ti, and is sufficiently lower than that of TiO$_2$ (the number of O atoms is twice of that of the Ti atoms). Accordingly, it can be found that oxygen is removed by the application of Ar plasma. It is to be noted that, by the application of Ar plasma, impurities such as Fe, Cr, and Al may be mixed into the interfaces of the connection layers 20A and 20B from a material of components configuring a plasma treatment apparatus. However, a particular issue is not caused in characteristics.

Evaluation was done on the contact resistance $\rho_c$ of the connection layer. Specifically, in a manner similar to that in [Step-110] in Example 1, a Ti layer having a thickness of 1.8 nm was formed on the p-type GaAs substrate. On the other hand, in a manner similar to that in [Step-110] in Example 1, a Ti layer having a thickness of 1.8 nm was formed on the n-type InP substrate. Further, in a manner similar to that in [Step-120] in Example 1, after performing plasma treatment on these Ti layers, the Ti layers were joined to each other at an ambient pressure of $1 \times 10^{-4}$ Pa, at a junction load of $2 \times 10^4$ N, and at a temperature of 25°C. Further, an electrode configured of Ti/Pt/Au was formed on an outer face of the p-type GaAs substrate and an outer face of the n-type InP substrate. Further, current-voltage characteristics of Sample-1 obtained in such a manner were measured, and the contact resistance $\rho_c$ in the junction interface was obtained based on the measurement result. Accordingly, the following result was obtained.

$$\rho_c(\text{Sample-1}) = 1.3 \times 10^{-4} \ \Omega \cdot \text{cm}^2$$

In Sample-2 in which the thickness of the Ti layer was changed from 1.8 nm to 1.0 nm, the following result was obtained.

$$\rho_c(\text{Sample-2}) = 1.5 \times 10^{-4} \ \Omega \cdot \text{cm}^2$$

It is to be noted that, in Sample-3 in which an electrode configured of Ti/Pt/Au was formed on each of the both faces of the p-type GaAs substrate, the following result was obtained.

$$\rho_c(\text{Sample-3}) = 8.1 \times 10^{-5} \ \Omega \cdot \text{cm}^2$$

Further, Sample-4 in which an electrode configured of Ti/Pt/Au was formed on each of the both faces of the n-type InP substrate, the following result was obtained.

$$\rho_c(\text{Sample-4}) = 5.4 \times 10^{-5} \ \Omega \cdot \text{cm}^2$$

In these measurements, favorable linear ohmic contact was obtained. As can be seen from the above-described results, $\rho_c \leq 1 \times 10^{-3} \ \Omega \cdot \text{cm}^2$ is achieved when the connection layer 20 is configured of the Ti layer having a thickness of 5 nm or less. Moreover, the contact resistance of Sample-1 or the contact resistance of Sample-2 is almost equal to sum of the contact resistance of Sample-3 and the contact resistance of Sample-4. Accordingly, it is found that electric loss in a case where the p-type GaAs substrate is joined to the n-type InP substrate with the use of the connection layer configured of the Ti layer is almost "0", and ideal junction is achieved.

Moreover, current-voltage characteristics were measured for Sample-5 in which the surfaces of the p-type GaAs substrate and the n-type InP substrate were allowed to be in an amorphous state, and the p-type GaAs substrate was joined to the n-type InP substrate through these surfaces in a method same as that in Sample 1, and for Sample-6 in which the thickness of the Ti layer was changed to 0.5 nm (a fabricating method is the same as that in Sample-1). As a result, current-voltage characteristics similar to those of Sample-1 were obtained. Accordingly, it is found that favorable linear ohmic contact is obtained also in the case where the compound semiconductor layers are allowed to be in the amorphous state and the junction is formed using them as the connection layers.

It is to be noted that, results similar to those described above were obtained also in a case where the connection layer was configured of Ti layer/Al layer instead of Ti layer/Ti layer.

EXAMPLE 2

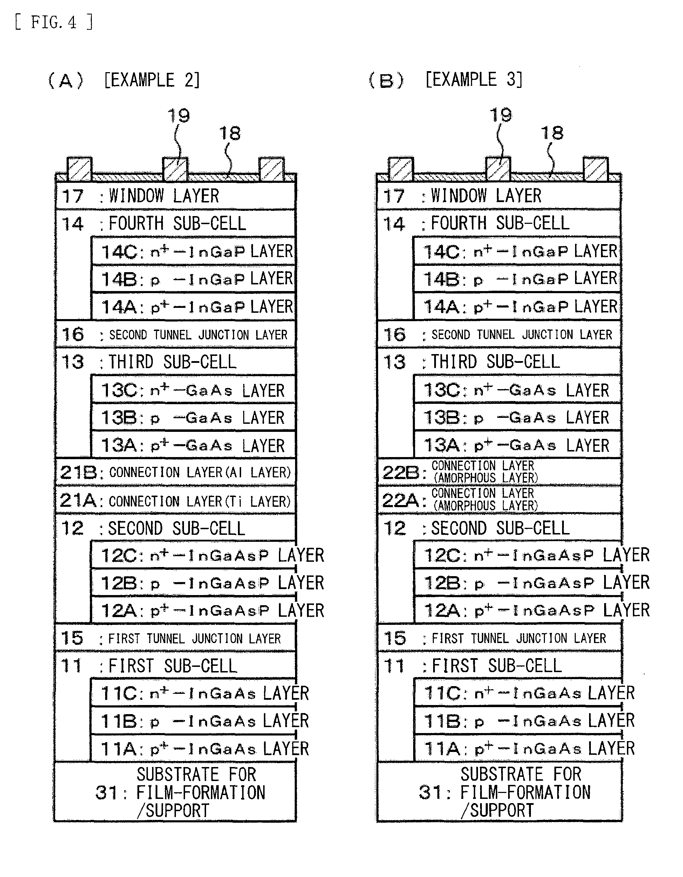

Example 2 is a modification of Example 1. (A) of FIG. 4 illustrates a conceptual diagram of a multi-junction solar cell, a compound semiconductor device, a photoelectric conversion device, and a compound-semiconductor-layer lamination structure in Example 2. In Example 2, a connection layer 21 has a lamination structure configured of a plurality of types (two types, in Example 2) of metal thin films. Specifically, for example, a Ti layer (a connection layer 21A) having a thickness of 0.5 nm may be formed on the compound semiconductor layer 12C configured of $\text{n}^+\text{-In}_{0.79}\text{Ga}_{0.21}\text{As}_{0.43}\text{P}_{0.57}$ configuring the second sub-cell 12, and on the other hand, an Al film (a connection layer 21B) having a thickness of 0.5 nm may be formed on the compound semiconductor layer 13A configured of $p^+$-GaAs configuring the third sub-cell 13. Subsequently, Ar plasma application is performed on these connection layers 21A and 21 B to activate surfaces thereof in a manner similar to that in [Step-120] in Example 1. Also, the connection layers 21A and 21 B are allowed to be amorphous, and then, are joined to each other. FIG. 24 shows a photograph of a cross-section, of a bonding junction interface, obtained by a transmission electron microscope. As can be seen from FIG. 24, because the connection layers are amorphous, crystal lattice is not viewable in the transmission electron microscope image. It is to be noted that metal used as the connection layer 21 may be selected appropriately from metal having ohmic characteristics and capable of forming a layer having a thickness of several nanometers or less, that may be, Al, Ti, Zr, Hf, W, Ta, Mo, Nb, or V. A combination of metal used as the connection layers 21A and 21B is not particularly limited. Metal exhibiting electric characteristics with favorable ohmic characteristics with respect to the compound semiconductor layers 12C and 13A forming the sub-cells 12 and 13 may be selected separately for the connection layers 21A and 21B, respectively. Accordingly, contact resistance is suppressed to the minimum.

EXAMPLE 3

Example 3 is also a modification of Example 1. Example 3 is different from Example 1 in that a connection layer 22 is configured of amorphous layers of compound semiconductors configuring the respective second sub-cell 12 and third sub-cell 13. (B) of FIG. 4 illustrates a conceptual diagram of a multi-junction solar cell, a compound semiconductor device, a photoelectric conversion device, and a compound-semiconductor-layer lamination structure in Example 3.

The connection layer 22 in Example 3 is configured of an $n^+$-$In_{0.79}Ga_{0.21}As_{0.43}P_{0.57}$ amorphous layer (a connection layer 22A) and a $p^+$-GaAs amorphous layer (a connection layer 22B). The $n^+$-$In_{0.79}Ga_{0.21}As_{0.43}P_{0.57}$ amorphous layer is obtained by allowing part of the compound semiconductor layer 12C configured of $n^+$-$In_{0.79}Ga_{0.21}As_{0.43}P_{0.57}$ configuring the second sub-cell 12 to be amorphous. The $p^+$-GaAs amorphous layer is obtained by allowing part of the compound semiconductor layer 13A configured of $p^+$-GaAs configuring the third sub-cell 13 to be amorphous. Dopant concentration of the connection layer 22A and the connection layer 22B may be, for example, from $1 \times 10^{18}$ $cm^{-3}$ to $5 \times 10^{19}$ $cm^{-3}$ both inclusive. A thickness of the connection layer 22 may be preferably from 0.5 nm to 3.0 nm both inclusive, for example. Further, thicknesses of the connection layers 22A and 22B may be preferably a half of that of the connection layer 22 after the junction, that is, from 0.25 nm to 1.5 nm both inclusive.

In Example 3, after forming the compound semiconductor layers, in a manner similar to that in [Step-120] in Example 1, the surfaces of the compound semiconductor layer 12C and the compound semiconductor layer 13A are activated by plasma treatment, and also, after the surfaces become amorphous, the second sub-cell 12 is joined to the third sub-cell 13. Specifically, Ar plasma (for example, at plasma density from $10^9$ $cm^{-3}$ to $10^{11}$ $cm^{-3}$ both inclusive, and at a pressure from 1 Pa to $10^{-2}$ Pa both inclusive) is applied to surfaces of the compound semiconductor layer 12C configured of $n^+$-$In_{0.79}Ga_{0.21}As_{0.43}P_{0.57}$ and the compound semiconductor layer 13A configured of $p^+$-GaAs, and plasma damage is caused on the surface of each of the compound semiconductor layers 12C and 13A. Accordingly, for example, an amorphous layer (the connection layers 22A and 22B) having a thickness of 1.0 nm may be formed. Further, the connection layers 22A and 22B are bonded to each other while maintaining high degree of vacuum (for example, at $5 \times 10^{-4}$ Pa or lower), in particular, for example, at an ambient pressure of $1 \times 10^{-4}$ Pa, at junction load of $2 \times 10^4$ N, and at a temperature of 25°C, and thereby, the second sub-cell 12 is joined to the third sub-cell 13.

In Example 3, the crystal structure of part of the compound semiconductor layers configuring each sub-cell is allowed to be amorphous between the sub-cells having different lattice constants, and this is used as the connection layers 22A and 22B. Accordingly, in a manner similar to that in Example 1, a multi-junction solar cell in which contact resistance in the junction interface of the joined compound semiconductor layers is low and high energy conversion efficiency is achieved is obtained. Further, in addition to such an effect, the step of forming the connection layer configured of metal becomes unnecessary. Therefore, manufacturing process is simplified, and manufacture cost is reduced.

EXAMPLE 4

Example 4 is also a modification of Example 1. Example 4 is different from Example 1 in that a first substrate for film formation and a second substrate for film formation are used, and these first substrate for film formation and second substrate for film formation are peeled off at last.

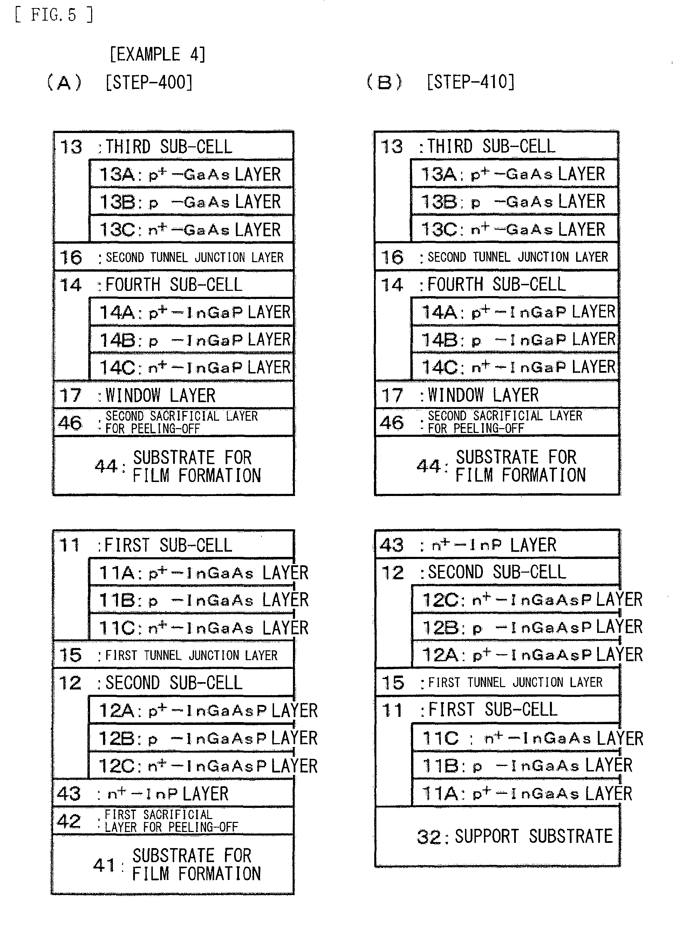

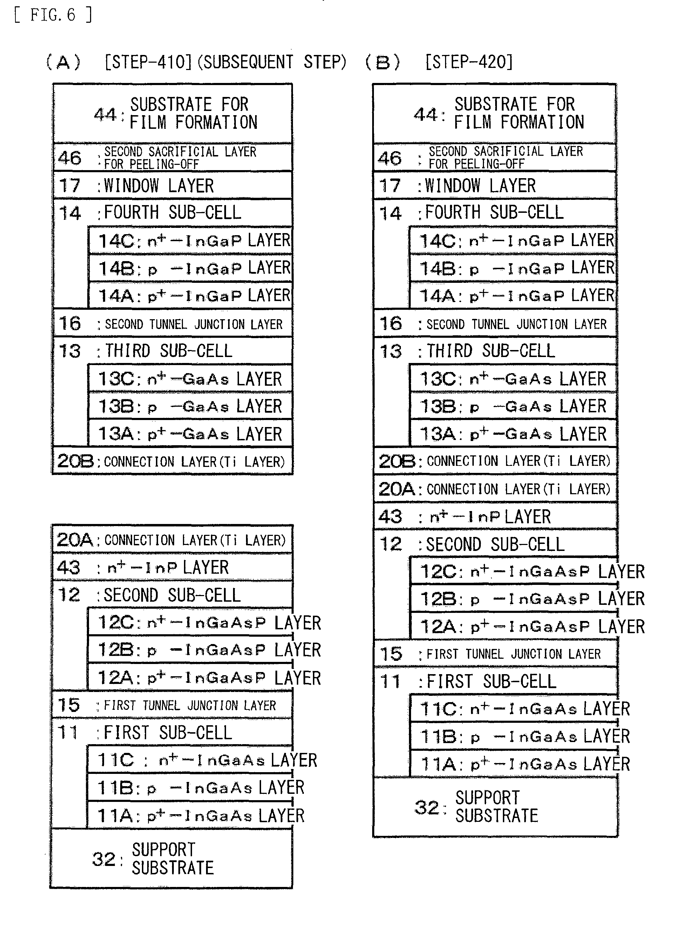

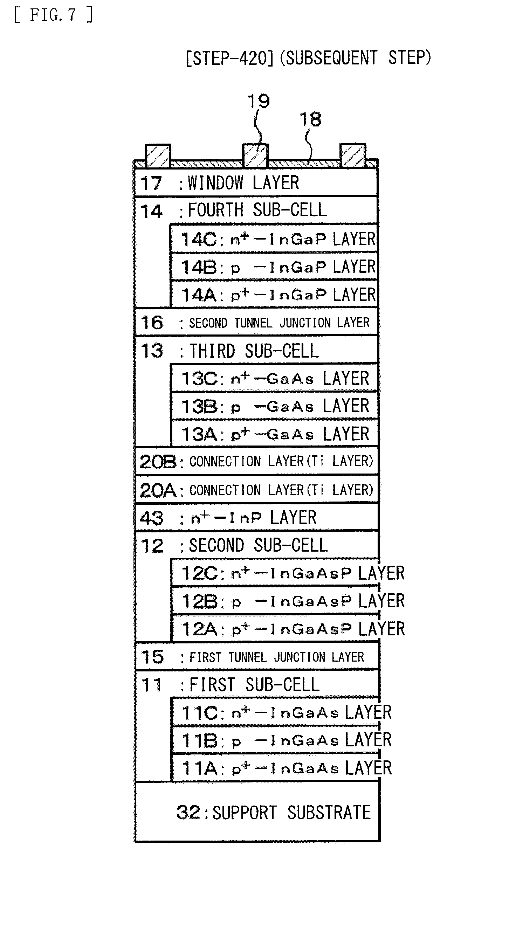

Description will be given below of a method of manufacturing a multi-junction solar cell, a compound semiconductor device, a photoelectric conversion device, and a compound-semiconductor-layer lamination structure in Example 4 referring to (A) to (B) of FIG. 5, (A) to (B) of FIG. 6, and FIG. 7 that are conceptual diagrams of the compound semiconductor layers and the like.

[Step-400]

First, a first sacrificial layer for peeling-off 42 made of AlInAs and an $n^+$-InP layer 43 that is to serve as a contact layer are formed on a first substrate for film formation 41 configured of an n-type InP substrate, and then, the second sub-cell 12, the first tunnel junction layer 15, and the first sub-cell 11 are sequentially formed on the $n^+$-InP layer 43. However, the formation of the $n^+$-InP layer 43 is not essential, and the formation may be omitted as in Example 1 to Example 3. The same is applicable also to Example 5 which will be described later. On the other hand, a second sacrificial layer for peeling-off 46 made of AlAs is formed on a second substrate for film formation 44 made of an n-type GaAs substrate, and then, the window layer 17, the fourth sub-cell 14, the second tunnel junction layer 16, and the third sub-cell 13 are sequentially formed. Thus, a structure shown in the conceptual diagram in (A) of FIG. 5 is obtained. It is to be noted that the $n^+$-InP layer 43 that is to serve as a contact layer may be formed in the multi-junction solar cells described in Example 1 to Example 3.

[Step-410]

Further, the first substrate for film formation 41 is peeled off by removing the first sacrificial layer for peeling-off 42 by etching after the surface of the first sub-cell 11 is bonded to the support substrate 32 (see (B) of FIG. 5). Thereafter, for example, the connection layer 20A made of Ti may be formed on the $n^+$-InP layer 43 formed on the compound semiconductor layer 12C made of $n^+$-$In_{0.79}Ga_{0.21}As_{0.43}P_{0.57}$ configuring the second sub-cell 12. On the other hand, for example, the connection layer 20B made of Ti may be formed on the compound semiconductor layer 13A made of $p^+$-GaAs configuring the third sub-cell 13. It is to be noted that the connection layers 20A and 20B are allowed to be formed in a manner similar to that in [Step-110] in Example 1. Thus, a structure shown in the conceptual diagram in (A) of FIG. 6 is obtained.

[Step-420]

Next, in a manner similar to that in [Step-120] in Example 1, the surfaces of the connection layers 20A and 20B are activated by Ar plasma application, and at the same time, are allowed to be amorphous. Thereafter, the connection layers 20A and 20B are joined to each other (see (B) of FIG. 6). Thereafter, after the second substrate for film formation 44 is peeled off by removing the second sacrificial layer for peeling-off 46 by etching, the second electrode 19 and the anti-reflection film 18 are formed in a manner similar to that in [Step-130] in Example 1. Thus, the multi-junction solar cell in Example 4 shown in the conceptual diagram in FIG. 7 is obtained.

In Example 4, not only the second substrate for film formation but also the first substrate for film formation is peeled off. Accordingly, the n-type GaAs substrate and the n-type InP substrate are both allowed to be reused, and therefore, manufacturing cost is further reduced.

It is to be noted that, in Example 4, although the connection layer is configured of Ti as in Example 1, the connection layer may have a configuration similar to that in Example 2 or Example 3. The same is applicable also to Example 5 which will be described next.

EXAMPLE 5

Example 5 is a modification of Example 4. Example 5 is different from Example 4 in that the first substrate for film formation and the second substrate for film formation are peeled off after the second sub-cell and the first sub-cell are formed on the first substrate for film formation and the third sub-cell and the fourth sub-cell are formed on the second substrate for film formation.

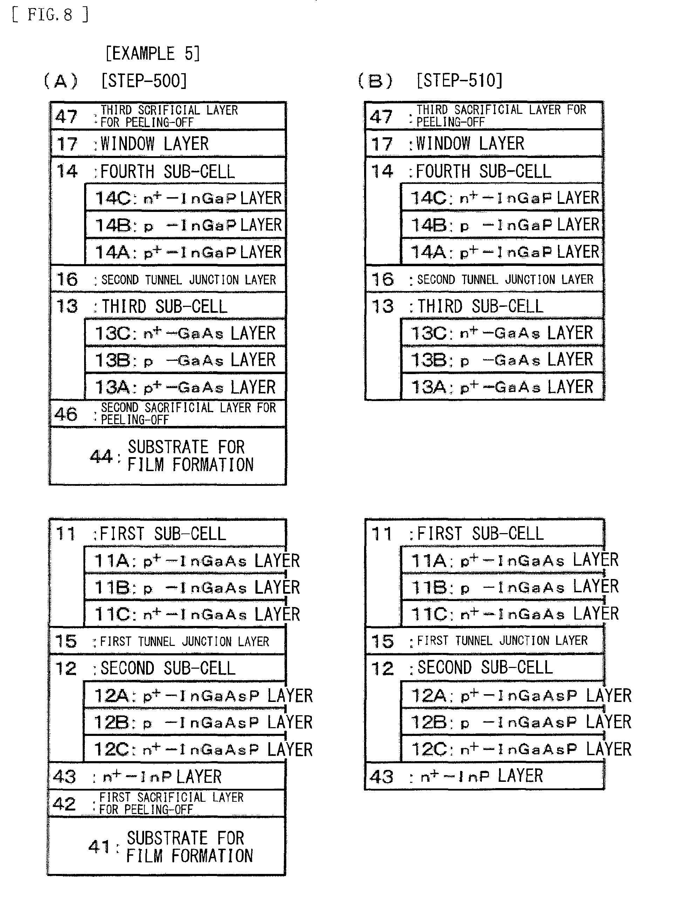

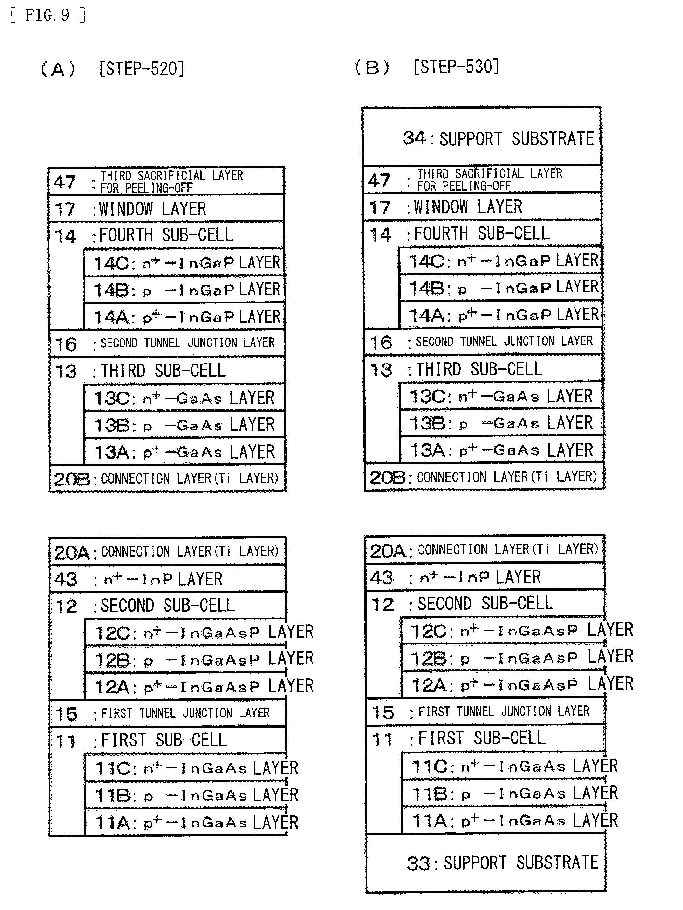

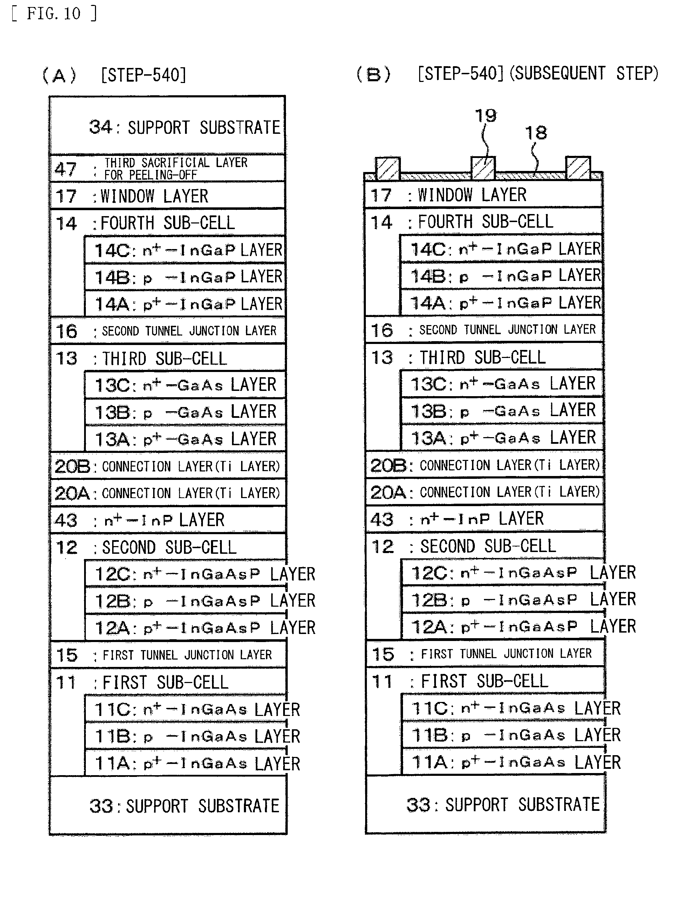

Description will be given below of a multi-junction solar cell, a compound semiconductor device, a photoelectric conversion device, and a compound-semiconductor-layer lamination structure in Example 5 referring to (A) to (B) of FIG. 8, (A) to (B) of FIG. 9, and (A) to (B) of FIG. 10 that are conceptual diagrams of the compound semiconductor layers and the like.

[Step-500]

First, in a manner similar to that in [Step-400] in Example 4, the first sacrificial layer for peeling-off 42, the $n^+$-InP layer 43, the second sub-cell 12, the first tunnel junction layer 15, and the first sub-cell 11 are sequentially formed on the first substrate for film formation 41 configured of the n-type InP substrate. On the other hand, the second sacrificial layer for peeling-off 46, the third sub-cell 13, the second tunnel junction layer 16, the fourth sub-cell 14, the window layer 17, and a third sacrificial layer for peeling-off 47 are sequentially formed on the second substrate for film formation 44 configured of an n-type GaAs substrate. Thus, a structure shown in the conceptual diagram in (A) of FIG. 8 is obtained.

[Step-510]

Thereafter, the first substrate for film formation 41 is peeled off by removing the first sacrificial layer for peeling-off 42 by etching. Further, the second substrate for film formation 44 is peeled off by removing the second sacrificial layer for peeling-off 46 by etching. Thus, a structure shown in the conceptual diagram in (B) of FIG. 8 is obtained.

[Step-520]

Next, for example, the connection layer 20A made of Ti may be formed on the $n^+$-InP layer 43 formed on the compound semiconductor layer 12C made of $n^+$-In$_{0.79}$Ga$_{0.21}$As$_{0.43}$P$_{0.57}$ configuring the second sub-cell 12. On the other hand, for example, the connection layer 20B made of Ti may be formed on the compound semiconductor layer 13A made of $p^+$-GaAs configuring the third sub-cell 13. It is to be noted that the connection layers 20A and 20B are allowed to be formed in a manner similar to that in [Step-110] in Example 1. Thus, a structure shown in the conceptual diagram in (A) of FIG. 9 is obtained.

[Step-530]

Thereafter, for example, the first sub-cell 11 may be bonded to the support substrate 33 and the third sacrificial layer for peeling-off 47 may be bonded to the support substrate 34 with the use of wax, a resist having high viscosity, or the like. Thus, a structure shown in the conceptual diagram in (B) of FIG. 9 is obtained.

[Step-540]

Subsequently, in a manner similar to that in [Step-120] in Example 1, the surfaces of the connection layers 20A and 20B are activated by Ar plasma application, and at the same time, are allowed to be amorphous. Thereafter, the connection layers 20A and 20B are joined to each other (see (A) of FIG. 10). Thereafter, the support substrate 34 is peeled off by removing the third sacrificial layer for peeling-off 47 by etching. Subsequently, the second electrode 19 and the anti-reflection film 18 are formed in a manner similar to that in [Step-130] in Example 1. Thus, the multi-junction solar cell in Example 5 shown in the conceptual diagram in (B) of FIG. 10 is obtained.

EXAMPLE 6

Example 6 relates to the compound semiconductor device, the photoelectric conversion device, and the compound-semiconductor-layer lamination structure of the present disclosure (hereinafter, collectively referred to as "photoelectric conversion device and the like"). More specifically, Example 6 relates to a multi-wavelength simultaneous (synchronous) oscillation laser.

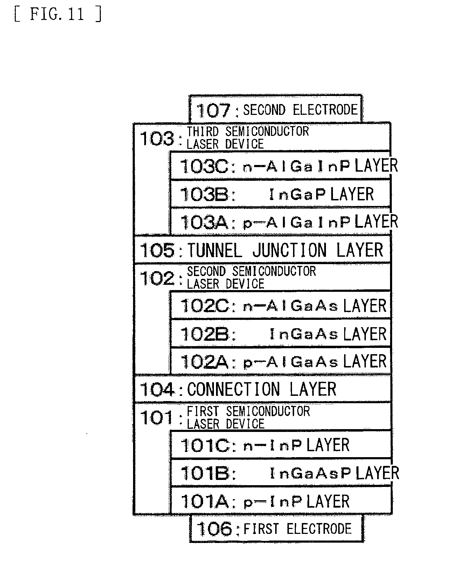

The photoelectric conversion device and the like in Example 6 shown in a schematic cross-sectional view in FIG. 11 is a multi-wavelength simultaneous oscillation laser, and includes a plurality of compound semiconductor layers 101A, 101B, 101C, 102A, 102B, 102C, 103A, 103B, and 103C that are laminated. Further, the compound semiconductor layer 101A, the compound semiconductor layer 101B, and the compound semiconductor layer 101C configure a first semiconductor laser device 101 that emits laser light having a certain wavelength. The compound semiconductor layer 102A, the compound semiconductor layer 102B, and the compound semiconductor layer 102C configure a second semiconductor laser device 102 that emits laser light having a wavelength different from that of the laser light emitted by the semiconductor laser device 101. The compound semiconductor layer 103A, the compound semiconductor layer 103B, and the compound semiconductor layer 103C configure a third semiconductor laser device 103 that emits laser light having a wavelength different from those of the laser light emitted by the semiconductor laser devices 101 and 102. Further, an amorphous connection layer 104 made of an electrically-conductive material (such as Ti) is provided between the first semiconductor laser device 101 and the second semiconductor laser device 102. Further, a tunnel junction layer 105 is formed between the second semiconductor laser device 102 and the third semiconductor laser device 103. Moreover, a first electrode 106 is formed on the compound semiconductor layer 101A configuring the first semiconductor laser device 101, and a second electrode 107 is formed on the compound semiconductor layer 103C configuring the third semiconductor laser device 103. Table 2 and Table 3 below show wavelengths of the laser light emitted by the respective semiconductor laser devices and compositions of the respective compound semiconductor layers and the like. According to the semiconductor laser device in Example 6, laser light having a wide wavelength range is allowed to be emitted at the same time, and multi-wavelength is allowed to be achieved with wavelengths in accordance with various applications such as medical application or microscope application.

[Table 2]

| | Wavelength of emitted laser light |
|---|---|
| Third semiconductor laser device 103 | From 0.65 $\mu$m to 0.69 $\mu$m both inclusive |
| Second semiconductor laser device 102 | From 0.78 $\mu$m to 0.88 $\mu$m both inclusive or 0.98 $\mu$m |
| First semiconductor laser device 101 | 1.1 $\mu$m, 1.3 $\mu$m, or from 1.55 $\mu$m to 2.5 $\mu$m both inclusive |

[Table 3]

| | Composition |
|---|---|
| Third semiconductor laser device 103 | |
| Compound semiconductor layer 103C | n-$(Al_{0.70}Ga_{0.30})_{0.52}In_{0.48}P$ |
| Compound semiconductor layer 103B | $In_{0.48}Ga_{0.52}P$ |
| Compound semiconductor layer 103A | p-$(Al_{0.70}Ga_{0.30})_{0.52}In_{0.48}P$ |
| Tunnel junction layer 105 | $p^+$-InGaAs (Upper layer) /$n^+$-InGaAs (Lower layer) |
| Second semiconductor laser device 102 | |
| Compound semiconductor layer 102C | n-$Al_{0.30}Ga_{0.70}As$ |
| Compound semiconductor layer 102B | $In_{0.08}Ga_{0.92}As$ |
| Compound semiconductor layer 102A | p-$Al_{0.30}Ga_{0.70}As$ |
| Connection layer 104 | Ti |
| First semiconductor laser device 101 | |
| Compound semiconductor layer 101C | n-InP |
| Compound semiconductor layer 101B | $(InP)_{1-Z}(Ga_{0.47}In_{0.53}As)_Z$ |
| Compound semiconductor layer 101A | p-InP |

EXAMPLE 7

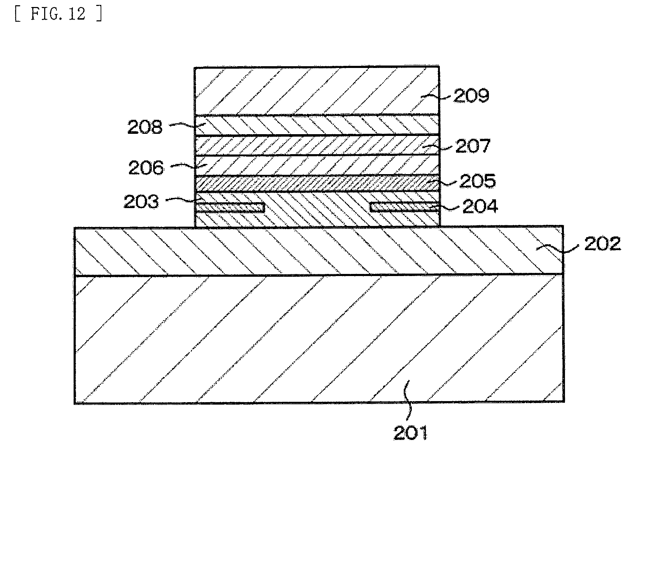

Example 7 also relates to the compound semiconductor device, the photoelectric conversion device, and the compound-semiconductor-layer lamination structure of the present disclosure (photoelectric conversion device and the like). More specifically, Example 7 relates to a surface-emitting laser device (a vertical resonator laser, VCSEL) of a long-wavelength type. FIG. 12 shows a schematic cross-sectional view of the surface-emitting laser device in Example 7. The surface-emitting laser device in Example 7 may have a structure in which, for example, a lower DBR (Distributed Bragg Reflector) layer 202 configured of Al(Ga)As/GaAs having a high reflection function, a current-confining layer 203 configured of an oxide layer including an $Al_xO_{1-x}$ layer 204, an amorphous connection layer 205 made of an electrically-conductive material (such as Ti), a lower spacer layer 206 made of n-InP, an active layer 207 configured of InGaAsP/InP, an upper spacer layer 208 configured of n-InP, and an upper DBR layer 209 configured of $SiO_2/TiO_2$ are laminated on the p-type GaAs substrate 201.

EXAMPLE 8

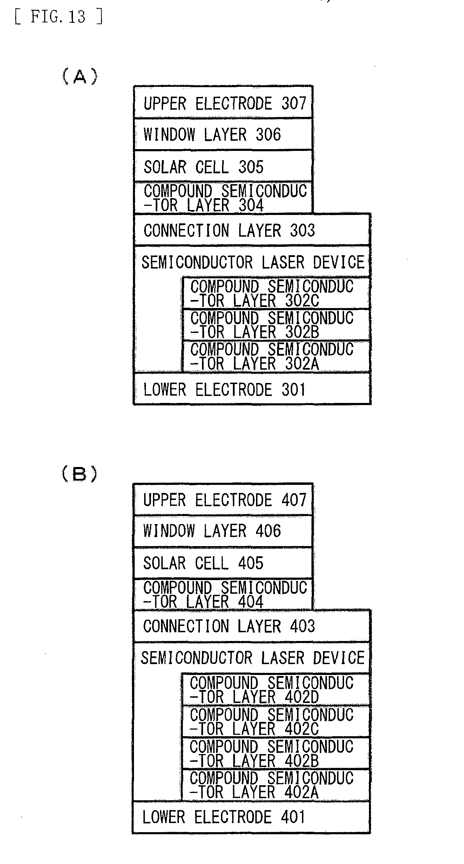

Example 8 also relates to the compound semiconductor device, the photoelectric conversion device, and the compound-semiconductor-layer lamination structure of the present disclosure (photoelectric conversion device and the like). More specifically, Example 8 relates to a photoelectric conversion device and the like of a self-power-generating type that has a structure in which a solar cell and a light emitting device (LED) are laminated. (A) and (B) of FIG. 13 show conceptual diagrams of the photoelectric conversion device and the like of the self-power-generating type in Example 8. The photoelectric conversion device and the like of the self-power-generating type in Example 8 shown in (A) of FIG. 13 is configured by laminating, on a lower electrode 301, a semiconductor laser device including a compound semiconductor layer 302A, a compound semiconductor layer 302B, and a compound semiconductor layer 302C that are laminated (an oscillation wavelength is 1.1 $\mu$m, 1.3 $\mu$m, 1.55 $\mu$m, or from 1.55 $\mu$m to 2.5 $\mu$m), an amorphous connection layer 303 made of an electrically-conductive material, a compound semiconductor layer 304, a solar cell 305, a window layer 306, and an upper electrode 307. The upper electrode 307 is connected to the lower electrode 301 and the connection layer 303 in an appropriate manner. Further, the photoelectric conversion device and the like of the self-power-generating type in Example 8 shown in (B) of FIG. 13 are each configured by laminating, on a lower electrode 401, a semiconductor laser device including a compound semiconductor layer 402A, a compound semiconductor layer 402B, a compound semiconductor layer 402C, and a compound semiconductor layer 402D that are laminated (a semiconductor laser device emitting blue or green), an amorphous connection layer 403 made of an electrically-conductive material, a compound semiconductor layer 404, a solar cell 405, a window layer 406, and an upper electrode 407. The upper electrode 407 is connected to the lower electrode 401 and the connection layer 403 in an appropriate manner. Table 4 and Table 5 below show, as examples, specific configurations of the respective compound semiconductor layers configuring the photoelectric conversion device and the like of the self-power-generating type in Example 8 shown in (A) and (B) of FIG. 13.

[Table 4]

| Window layer 306 | : AlInP |
| Solar cell 305 | : $n^+$-GaAs/p-GaAs |
| Compound semiconductor layer 304 | : $p^+$-GaAs |
| Connection layer 303 | : Ti or Al |
| Semiconductor laser device | |
| Compound semiconductor layer 302C | n-InP |
| Compound semiconductor layer 302B | $(InP)_{1-Z}(Ga_{0.47}In_{0.53}As)_Z$ |
| Compound semiconductor layer 302A | p-InP |

[Table 5]

| Window layer 406 | : AlN |
| Solar cell 405 | : n-AlGaN/p-AlGaN |
| Compound semiconductor layer 404 | : $p^+$-GaN |
| Connection layer 403 | : Pd |
| Semiconductor laser device | |
| Compound semiconductor layer 402D | : n-GaN |
| Compound semiconductor layer 402C | : $n$-$Al_{0.05}Ga_{0.95}N$ |
| Compound semiconductor layer 402B | : $In_{0.30}Ga_{0.70}N$ |
| Compound semiconductor layer 402A | : $p$-$Al_{0.05}Ga_{0.95}N$ |

Hereinabove, the present disclosure has been described based on preferable Examples. However, the present disclosure is not limited to these Examples. The configurations, the structures, the compositions, and the like of the multi-junction solar cell, the compound semiconductor device, the photoelectric conversion device, the compound-semiconductor-layer lamination structure, or the like in the Examples are allowed to be changed as appropriate. It is not necessary to provide all of the various compound semiconductor layers configuring the multi-junction solar cells, the compound semiconductor devices, the photoelectric conversion devices, and the like described in the Examples, and other layers may be provided. Further, the junction of the connection layers 20A and 20B may be formed, for example, at 200°C, and thereby, contact resistance of the junction interface is further reduced.

Since the substrate for film formation is removed at last, the conductivity type of the substrate may be either the n-type or the p-type. Further, since the substrate for film formation is allowed to be reused, the manufacturing cost of the multi-junction solar cell, the photoelectric conversion device, and the compound semiconductor device, and the like is reduced.

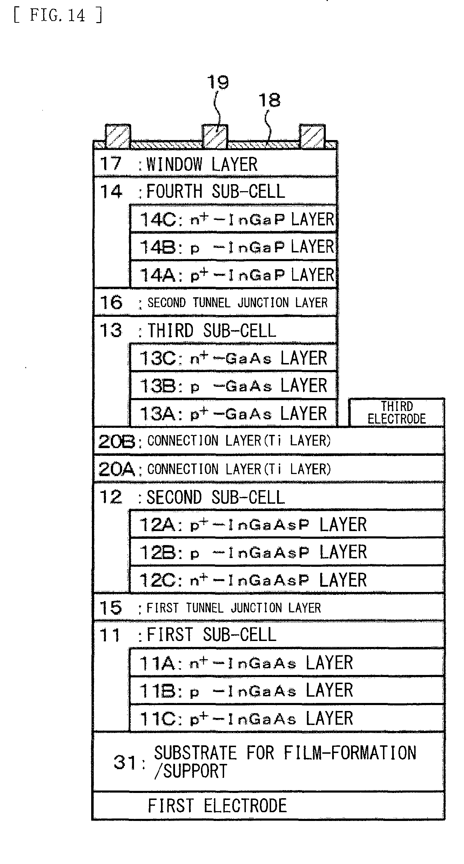

For example, the multi-junction solar cell shown in the conceptual diagram in FIG. 3 may be a structure in which the connection layer 20 is extended to an outer side and may configure a third electrode as shown in FIG. 14. Accordingly, a parallel multi-junction solar cell is configured that is allowed to easily face a region in which spectrum of solar light is different from AM1.5, variation in climate, etc. It is to be noted that, in the multi-junction solar cell shown in FIG. 14, a lamination order of compound semiconductor layers $11A_1$, $11A_2$, and 11C, and the compound semiconductor layers 12A, 12B, and 12C in the first sub-cell 11 and the second sub-cell 12 is the reverse of a lamination order of the compound semiconductor layers 11A, 11B, and 11C and the compound semiconductor layers 12A, 12B, and 12C in the first sub-cell 11 and the second sub-cell 12 in the multi-junction solar cell in Example 1 shown in FIG. 3, and the first sub-cell 11 and the second sub-cell 12 are connected in parallel to the third sub-cell 13 and the fourth sub-cell 14. Further, in order to reduce electric resistance to the third electrode, for example, a thickness of the $p^+$-InP layer 43 may be desirably larger.

In the Examples, a configuration including, in order from the light incident side, for example,

Fourth sub-cell: InGaP layer
Third sub-cell: GaAs layer
Second sub-cell: InGanAsP layer
First sub-cell: InGaAs layer

has been adopted. However, alternatively, for example, [Configuration-A] to [Configuration-D] that are configurations shown in Table 6 below in order from the light incident side may be adopted. Alternatively, Table 7 below shows [Configuration-E] to [Configuration-H] that are each a configuration in which the second sub-cell, the third sub-cell, and the fourth sub-cell are formed on the GaAs substrate, the first sub-cell is formed on the InP substrate, and the first sub-cell is joined to the second sub-cell, and [Configuration-I] that is a configuration in which the third sub-cell, the fourth sub-cell, and the fifth sub-cell are formed on the GaAs substrate, the first sub-cell and the second sub-cell are formed on the InP substrate, and the second sub-cell is joined to the third sub-cell. It is to be noted that a third column in Table 6 to Table 7 shows values of band gaps, and a fourth column therein shows values of lattice constants. Further, in Table 6 to Table 7, compound semiconductor layers that have the same composition but have different values of band gaps or different values of lattice constants have different atomic percentages.

[Table 6]

| [Configuration-A] | | | |
|---|---|---|---|
| Fourth sub-cell | InGaP layer | 1.90 eV | 5.653 Å |
| Third sub-cell | GaAs laver | 1.42 eV | 5.653 Å |
| Second sub-cell | InGaAsP layer | 1.03 eV | 5.868 Å |
| First sub-cell | $In_{0.53}Ga_{0.47}As$ layer | 0.75 eV | 5.868 Å |
| | | | |
| [Configuration-B] | | | |
| Fourth sub-cell | AlInGaP layer | 2.10 eV | 5.722 Å |
| Third sub-cell | $In_{0.65}Ga_{0.35}P$ layer | 1.66 eV | 5.722 Å |
| Second sub-cell | InGaAsP layer | 1.03 eV | 5.868 Å |
| First sub-cell | $In_{0.53}Ga_{0.47}As$ layer | 0.75 eV | 5.868 Å |
| | | | |
| [Configuration-C] | | | |
| Fourth sub-cell | InGaP layer | 1.90 eV | 5.653 Å |
| Third sub-cell | $In_{0.01}Ga_{0.99}As$ laver | 1.40 eV | 5.657 Å |
| Second sub-cell | InGaAsP layer | 1.03 eV | 5.868 Å |
| First sub-cell | $In_{0.53}Ga_{0.47}As$ layer | 0.75 eV | 5.868 Å |
| | | | |
| [Configuration-D] | | | |
| Fourth sub-cell | AlInGaP layer | 2.10 eV | 5.722 Å |
| Third sub-cell | $In_{0.65}Ga_{0.35}P$ layer | 1.66 eV | 5.722 Å |
| Second sub-cell | InGaAsP layer | 1.03 eV | 5.868 Å |
| First sub-cell | $In_{0.53}Ga_{0.47}As$ layer | 0.75 eV | 5.868 Å |

[Table 7]

| [Configuration-E] | | | |
|---|---|---|---|
| Fourth sub-cell | $Al_{0.015}InGa_{0.985}P$ layer | 1.90 eV | 5.653 Å |
| Third sub-cell | GaAs layer | 1.42 eV | 5.653 Å |

(continued)

| [Configuration-E] | | | |
|---|---|---|---|
| Second sub-cell | InGaAsN layer | 1.00 eV | 5.653 Å |
| First sub-cell | $In_{0.53}Ga_{0.47}As$ layer | 0.75 eV | 5.868 Å |
| | | | |
| [Configuration-F] | | | |
| Fourth sub-cell | $Al_{0.015}InGa_{0.985}P$ layer | 1.90 eV | 5.653 Å |
| Third sub-cell | $In_{0.01}Ga_{0.99}As$ layer | 1.40 eV | 5.657 Å |
| Second sub-cell | InGaAsN layer | 1.00 eV | 5.653 Å |
| First sub-cell | $In_{0.53}Ga_{0.47}As$ layer | 0.75 eV | 5.868 Å |
| | | | |
| [Configuration-G] | | | |
| Fourth sub-cell | InGaP layer | 1.90 eV | 5.653 Å |
| Third sub-cell | $In_{0.01}Ga_{0.99}As$ layer | 1.40 eV | 5.657 Å |
| Second sub-cell | InGaAsN layer | 1.00 eV | 5.653 Å |
| First sub-cell | $In_{0.53}Ga_{0.47}As$ layer | 0.75 eV | 5.868 Å |
| | | | |
| [Configuration-H] | | | |
| Fourth sub-cell | InGaP layer | 1.90 eV | 5.653 Å |
| Third sub-cell | GaAs layer | 1.42 eV | 5.653 Å |
| Second sub-cell | InGaAsN layer | 1.00 eV | 5.653 Å |
| First sub-cell | $In_{0.53}Ga_{0.47}As$ layer | 0.75 eV | 5.868 Å |
| | | | |
| [Configuration-I] | | | |
| Fifth sub-cell | $Al_{0.27}InGa_{0.73}P$ layer | 2.20 eV | 5.653 Å |
| Fourth sub-cell | InGaP layer | 1.80 eV | 5.657 Å |
| Third sub-cell | GaAs layer | 1.42 eV | 5.653 Å |
| Second sub-cell | InGaAsP layer | 1.03 eV | 5.868 Å |
| First sub-cell | $In_{0.53}Ga_{0.47}As$ layer | 0.75 eV | 5.868 Å |

Moreover, it is not limited to the four-junction type as described above, and a multi-junction solar cell having less-than-four junctions may be achieved, or a multi-junction solar cell having five-or-more junctions (for example, AlInGaP layer/InGaP layer/AlGaAs layer/ InGaAs layer/ InGaAsN layer/ Ge layer) may be achieved.

It is to be noted that the present disclosure may have configurations such as the followings.

[1] [Multi-junction solar cell]
A multi-junction solar cell including

a plurality of sub-cells that are laminated, the plurality of sub-cells each being configured of a plurality of compound semiconductor layers that are laminated, wherein
an amorphous connection layer made of an electrically-conductive material is provided in at least one place between the sub-cells adjacent to each other.

[2] The multi-junction solar cell according to [1], wherein a tunnel junction layer is provided in each place, between the sub-cells adjacent to each other, in which the connection layer is not provided.

[3] The multi-junction solar cell according to [1] or [2], wherein the connection layer includes at least one type of atom selected from a group consisting of titanium, aluminum, zirconium, hafnium, tungsten, tantalum, molybdenum, niobium, and vanadium.

[4] The multi-junction solar cell according to [3], wherein the connection layer has a thickness of 5 nanometers or smaller.

[5] The multi-junction solar cell according to [1] or [2], wherein the connection layer is configured of a material selected from a group consisting of AZO, IZO, GZO, IGO, IGZO, and ITO.

[6] The multi-junction solar cell according to [1] or [2], wherein the connection layer is made of an amorphous semiconductor.

[7] The multi-junction solar cell according to any one of [1] to [6], wherein conductivity types of the compound semiconductor layers facing each other in the sub-cells adjacent to each other are different.

[8] The multi-junction solar cell according to [7], wherein a thickness of a compound semiconductor layer having a conductivity type of a p-type in the compound semiconductor layers configuring the sub-cells is 100 nanometers or smaller.

[9] The multi-function solar cell according to any one of [1] to [8], wherein the compound semiconductor layers are configured of GaAs or InP.

[10] [Compound semiconductor device]
A compound semiconductor device including

a plurality of a plurality of compound semiconductor layers that are laminated, wherein
an amorphous connection layer made of an electrically-conductive material is provided in at least one place between the compound semiconductor layers adjacent to each other.

[11] The compound semiconductor device according to [10], wherein the connection layer includes at least one type of atom selected from a group consisting of titanium, aluminum, zirconium, hafnium, tungsten, tantalum, molybdenum, niobium, and vanadium.

[12] The compound semiconductor device according to [11], wherein the connection layer has a thickness of 5 nanometers or smaller.

[13] The compound semiconductor device according to [10], wherein the connection layer is configured of a material selected from a group consisting of AZO, IZO, GZO, IGO, IGZO, and ITO.

[14] The compound semiconductor device according to [10], wherein the connection layer is made of an amorphous semiconductor.

[15] The compound semiconductor device according to any one of [11] to [14], wherein conductivity types of the compound semiconductor layers facing each other with the connection layer in between are different.

[16] The compound semiconductor device according to any one of [11] to [15], wherein the compound semiconductor layers are configured of GaAs or InP.

[17] [Photoelectric conversion device]
A photoelectric conversion device including

a plurality of a plurality of compound semiconductor layers that are laminated, wherein
an amorphous connection layer made of an electrically-conductive material is provided in at least one place between the compound semiconductor layers adjacent to each other.

[18] [Compound-semiconductor-layer lamination structure]
A compound-semiconductor-layer lamination structure including

a plurality of a plurality of compound semiconductor layers that are laminated, wherein
an amorphous connection layer made of an electrically-conductive material is provided in at least one place between the compound semiconductor layers adjacent to each other.

This application claims the priority based on P.R.C Patent Application No. 201110281336.6 filed September 21, 2011 in State Intellectual Property Office of The P.R.C, the entire contents of each which are incorporated in this application by reference.

**Claims**

1.  A multi-junction solar cell comprising
    a plurality of sub-cells that are laminated, the plurality of sub-cells each being configured of a plurality of compound semiconductor layers that are laminated, wherein
    an amorphous connection layer made of an electrically-conductive material is provided in at least one place between the sub-cells adjacent to each other.

2.  The multi-junction solar cell according to claim 1, wherein a tunnel junction layer is provided in each place, between the sub-cells adjacent to each other, in which the connection layer is not provided.

3.  The multi-junction solar cell according to claim 1, wherein the connection layer includes at least one type of atom selected from a group consisting of titanium, aluminum, zirconium, hafnium, tungsten, tantalum, molybdenum, niobium, and vanadium.

4.  The multi-junction solar cell according to claim 3, wherein the connection layer has a thickness of 5 nanometers or smaller.

5.  The multi-junction solar cell according to claim 1, wherein the connection layer is configured of a material selected from a group consisting of AZO, IZO, GZO, IGO, IGZO, and ITO.

6.  The multi-junction solar cell according to claim 1, wherein the connection layer is made of an amorphous semiconductor.

7.  The multi-junction solar cell according to claim 1, wherein conductivity types of the compound semiconductor layers facing each other in the sub-cells adjacent to each other are different.

8.  The multi-junction solar cell according to claim 7, wherein a thickness of a compound semiconductor layer having a conductivity type of a p-type in the compound semiconductor layers configuring the sub-cells is 100 nanometers or smaller.

9.  The multi-function solar cell according to claim 1, wherein the compound semiconductor layers are configured of GaAs or InP.

10. A compound semiconductor device comprising
    a plurality of compound semiconductor layers that are laminated, wherein
    an amorphous connection layer made of an electrically-conductive material is provided in at least one place between the compound semiconductor layers adjacent to each other.

11. The compound semiconductor device according to claim 10, wherein the connection layer includes at least one type of atom selected from a group consisting of titanium, aluminum, zirconium, hafnium, tungsten, tantalum, molybdenum, niobium, and vanadium.

12. The compound semiconductor device according to claim 11, wherein the connection layer has a thickness of 5 nanometers or smaller.

13. The compound semiconductor device according to claim 10, wherein the connection layer is configured of a material selected from a group consisting of AZO, IZO, GZO, IGO, IGZO, and ITO.

14. The compound semiconductor device according to claim 10, wherein the connection layer is made of an amorphous semiconductor.

15. The compound semiconductor device according to claim 10, wherein conductivity types of the compound semiconductor layers facing each other with the connection layer in between are different.

16. The compound semiconductor device according to claim 10, wherein the compound semiconductor layers are configured of GaAs or InP.

**17.** A photoelectric conversion device comprising
a plurality of compound semiconductor layers that are laminated, wherein
an amorphous connection layer made of an electrically-conductive material is provided in at least one place between
the compound semiconductor layers adjacent to each other.

**18.** A compound-semiconductor-layer lamination structure comprising
a plurality of compound semiconductor layers that are laminated, wherein
an amorphous connection layer made of an electrically-conductive material is provided in at least one place between
the compound semiconductor layers adjacent to each other.

[ FIG. 1 ]

[EXAMPLE 1]

(A) [STEP-100]

| 13 : THIRD SUB-CELL |
|---|
| 13A: p⁺−GaAs LAYER |
| 13B: p −GaAs LAYER |
| 13C: n⁺−GaAs LAYER |
| 16 : SECOND TUNNEL JUNCTION LAYER |
| 14 : FOURTH SUB-CELL |
| 14A: p⁺−InGaP LAYER |
| 14B: p −InGaP LAYER |
| 14C: n⁺−InGaP LAYER |
| 17 : WINDOW LAYER |
| 45 : SACRIFICIAL LAYER FOR PEELING-OFF |
| 44: SUBSTRATE FOR FILM FORMATION |

| 12 : SECOND SUB-CELL |
|---|
| 12C: n⁺−InGaAsP LAYER |
| 12B: p −InGaAsP LAYER |
| 12A: p⁺−InGaAsP LAYER |
| 15 : FIRST TUNNEL JUNCTION LAYER |
| 11 : FIRST SUB-CELL |
| 11C: n⁺−InGaAs LAYER |
| 11B: p −InGaAs LAYER |
| 11A: p⁺−InGaAs LAYER |
| 31: SUBSTRATE FOR FILM-FORMATION /SUPPORT |

(B) [STEP-110]

| 20B: CONNECTION LAYER (Ti LAYER) |
|---|
| 13 : THIRD SUB-CELL |
| 13A: p⁺−GaAs LAYER |
| 13B: p −GaAs LAYER |
| 13C: n⁺−GaAs LAYER |
| 16 : SECOND TUNNEL JUNCTION LAYER |
| 14 : FOURTH SUB-CELL |
| 14A: p⁺−InGaP LAYER |
| 14B: p −InGaP LAYER |
| 14C: n⁺−InGaP LAYER |
| 17 : WINDOW LAYER |
| 45 : SACRIFICIAL LAYER FOR PEELING-OFF |
| 44: SUBSTRATE FOR FILM FORMATION |

| 20A: CONNECTION LAYER (Ti LAYER) |
|---|
| 12 : SECOND SUB-CELL |
| 12C: n⁺−InGaAsP LAYER |
| 12B: p −InGaAsP LAYER |
| 12A: p⁺−InGaAsP LAYER |
| 15 : FIRST TUNNEL JUNCTION LAYER |
| 11 : FIRST SUB-CELL |
| 11C: n⁺−InGaAs LAYER |
| 11B: p −InGaAs LAYER |
| 11A: p⁺−InGaAs LAYER |
| 31: SUBSTRATE FOR FILM-FORMATION /SUPPORT |

[ FIG. 2 ]

(A)  [STEP-120]

| 44 : SUBSTRATE FOR FILM FORMATION |
|---|
| 45 : SACRIFICIAL LAYER FOR PEELING-OFF |
| 17 : WINDOW LAYER |
| 14 : FOURTH SUB-CELL |
| 14C: $n^+$ — InGaP LAYER |
| 14B: p — InGaP LAYER |
| 14A: $p^+$ — InGaP LAYER |
| 16 : SECOND TUNNEL JUNCTION LAYER |
| 13 : THIRD SUB-CELL |
| 13C: $n^+$ — GaAs LAYER |
| 13B: p — GaAs LAYER |
| 13A: $p^+$ — GaAs LAYER |
| 20B : CONNECTION LAYER (Ti LAYER) |
| 20A : CONNECTION LAYER (Ti LAYER) |
| 12 : SECOND SUB-CELL |
| 12C: $n^+$ — InGaAsP LAYER |
| 12B: p — InGaAsP LAYER |
| 12A: $p^+$ — InGaAsP LAYER |
| 15 : FIRST TUNNEL JUNCTION LAYER |
| 11 : FIRST SUB-CELL |
| 11C: $n^+$ — InGaAs LAYER |
| 11B: p — InGaAs LAYER |
| 11A: $p^+$ — InGaAs LAYER |
| 31 : SUBSTRATE FOR FILM-FORMATION /SUPPORT |

(B)  [STEP-130]

| 17 : WINDOW LAYER |
|---|
| 14 : FOURTH SUB-CELL |
| 14C: $n^+$ — InGaP LAYER |
| 14B: p — InGaP LAYER |
| 14A: $p^+$ — InGaP LAYER |
| 16 : SECOND TUNNEL JUNCTION LAYER |
| 13 : THIRD SUB-CELL |
| 13C: $n^+$ — GaAs LAYER |
| 13B: p — GaAs LAYER |
| 13A: $p^+$ — GaAs LAYER |
| 20B : CONNECTION LAYER (Ti LAYER) |
| 20A : CONNECTION LAYER (Ti LAYER) |
| 12 : SECOND SUB-CELL |
| 12C: $n^+$ — InGaAsP LAYER |
| 12B: p — InGaAsP LAYER |
| 12A: $p^+$ — InGaAsP LAYER |
| 15 : FIRST TUNNEL JUNCTION LAYER |
| 11 : FIRST SUB-CELL |
| 11C: $n^+$ — InGaAs LAYER |
| 11B: p — InGaAs LAYER |
| 11A: $p^+$ — InGaAs LAYER |
| 31 : SUBSTRATE FOR FILM-FORMATION /SUPPORT |

[ FIG. 3 ]

[STEP-130] (SUBSEQUENT STEP)

19    18

| 17 : WINDOW LAYER |
|---|
| 14 : FOURTH SUB-CELL |
| 14C: $n^+$ − InGaP LAYER |
| 14B: p − InGaP LAYER |
| 14A: $p^+$ − InGaP LAYER |
| 16 : SECOND TUNNEL JUNCTION LAYER |
| 13 : THIRD SUB-CELL |
| 13C: $n^+$ − GaAs LAYER |
| 13B: p − GaAs LAYER |
| 13A: $p^+$ − GaAs LAYER |
| 20B: CONNECTION LAYER (Ti LAYER) |
| 20A: CONNECTION LAYER (Ti LAYER) |
| 12 : SECOND SUB-CELL |
| 12C: $n^+$ − InGaAsP LAYER |
| 12B: p − InGaAsP LAYER |
| 12A: $p^+$ − InGaAsP LAYER |
| 15 : FIRST TUNNEL JUNCTION LAYER |
| 11 : FIRST SUB-CELL |
| 11C : $n^+$ − InGaAs LAYER |
| $11A_2$: p − InGaAs LAYER |
| $11A_1$: $p^+$ − InGaAs LAYER |
| 31 : SUBSTRATE FOR FILM-FORMATION /SUPPORT |

[ FIG. 4 ]

(A)  [EXAMPLE 2]

19
18

| 17 : WINDOW LAYER |
| 14 : FOURTH SUB-CELL |
| 14C: $n^+-$InGaP LAYER |
| 14B: $p$ $-$InGaP LAYER |
| 14A: $p^+-$InGaP LAYER |
| 16 : SECOND TUNNEL JUNCTION LAYER |
| 13 : THIRD SUB-CELL |
| 13C: $n^+-$GaAs LAYER |
| 13B: $p$ $-$GaAs LAYER |
| 13A: $p^+-$GaAs LAYER |
| 21B: CONNECTION LAYER (Al LAYER) |
| 21A: CONNECTION LAYER (Ti LAYER) |
| 12 : SECOND SUB-CELL |
| 12C: $n^+-$InGaAsP LAYER |
| 12B: $p$ $-$InGaAsP LAYER |
| 12A: $p^+-$InGaAsP LAYER |
| 15 : FIRST TUNNEL JUNCTION LAYER |
| 11 : FIRST SUB-CELL |
| 11C: $n^+-$InGaAs LAYER |
| 11B: $p$ $-$InGaAs LAYER |
| 11A: $p^+-$InGaAs LAYER |
| 31: SUBSTRATE FOR FILM-FORMATION /SUPPORT |

(B)  [EXAMPLE 3]

19
18

| 17 : WINDOW LAYER |
| 14 : FOURTH SUB-CELL |
| 14C: $n^+-$InGaP LAYER |
| 14B: $p$ $-$InGaP LAYER |
| 14A: $p^+-$InGaP LAYER |
| 16 : SECOND TUNNEL JUNCTION LAYER |
| 13 : THIRD SUB-CELL |
| 13C: $n^+-$GaAs LAYER |
| 13B: $p$ $-$GaAs LAYER |
| 13A: $p^+-$GaAs LAYER |
| 22B: CONNECTION LAYER (AMORPHOUS LAYER) |
| 22A: CONNECTION LAYER (AMORPHOUS LAYER) |
| 12 : SECOND SUB-CELL |
| 12C: $n^+-$InGaAsP LAYER |
| 12B: $p$ $-$InGaAsP LAYER |
| 12A: $p^+-$InGaAsP LAYER |
| 15 : FIRST TUNNEL JUNCTION LAYER |
| 11 : FIRST SUB-CELL |
| 11C: $n^+-$InGaAs LAYER |
| 11B: $p$ $-$InGaAs LAYER |
| 11A: $p^+-$InGaAs LAYER |
| 31: SUBSTRATE FOR FILM-FORMATION /SUPPORT |

[ FIG. 5 ]

[EXAMPLE 4]

(A)  [STEP-400]                          (B)  [STEP-410]

| 13 :THIRD SUB-CELL |
| 13A: p⁺−GaAs LAYER |
| 13B: p −GaAs LAYER |
| 13C: n⁺−GaAs LAYER |
| 16 : SECOND TUNNEL JUNCTION LAYER |
| 14 :FOURTH SUB-CELL |
| 14A: p⁺−InGaP LAYER |
| 14B: p −InGaP LAYER |
| 14C: n⁺−InGaP LAYER |
| 17 :WINDOW LAYER |
| 46 : SECOND SACRIFICIAL LAYER : FOR PEELING-OFF |
| 44: SUBSTRATE FOR FILM FORMATION |

| 13 :THIRD SUB-CELL |
| 13A: p⁺−GaAs LAYER |
| 13B: p −GaAs LAYER |
| 13C: n⁺−GaAs LAYER |
| 16 : SECOND TUNNEL JUNCTION LAYER |
| 14 :FOURTH SUB-CELL |
| 14A: p⁺−InGaP LAYER |
| 14B: p −InGaP LAYER |
| 14C: n⁺−InGaP LAYER |
| 17 :WINDOW LAYER |
| 46 : SECOND SACRIFICIAL LAYER : FOR PEELING-OFF |
| 44: SUBSTRATE FOR FILM FORMATION |

| 11 :FIRST SUB-CELL |
| 11A: p⁺−InGaAs LAYER |
| 11B: p −InGaAs LAYER |
| 11C: n⁺−InGaAs LAYER |
| 15 : FIRST TUNNEL JUNCTION LAYER |
| 12 :SECOND SUB-CELL |
| 12A: p⁺−InGaAsP LAYER |
| 12B: p −InGaAsP LAYER |
| 12C: n⁺−InGaAsP LAYER |
| 43 : n⁺−InP LAYER |
| 42 : FIRST SACRIFICIAL : LAYER FOR PEELING-OFF |
| 41: SUBSTRATE FOR FILM FORMATION |

| 43 : n⁺−InP LAYER |
| 12 :SECOND SUB-CELL |
| 12C: n⁺−InGaAsP LAYER |
| 12B: p −InGaAsP LAYER |
| 12A: p⁺−InGaAsP LAYER |
| 15 : FIRST TUNNEL JUNCTION LAYER |
| 11 :FIRST SUB-CELL |
| 11C : n⁺−InGaAs LAYER |
| 11B: p −InGaAs LAYER |
| 11A: p⁺−InGaAs LAYER |
| 32: SUPPORT SUBSTRATE |

[ FIG. 6 ]

(A)  [STEP-410] (SUBSEQUENT STEP)  (B)  [STEP-420]

| 44 : SUBSTRATE FOR FILM FORMATION |
| --- |
| 46 : SECOND SACRIFICIAL LAYER FOR PEELING-OFF |
| 17 : WINDOW LAYER |
| 14 : FOURTH SUB-CELL |
| 14C: $n^+$ − InGaP LAYER |
| 14B: $p$ − InGaP LAYER |
| 14A: $p^+$ − InGaP LAYER |
| 16 : SECOND TUNNEL JUNCTION LAYER |
| 13 : THIRD SUB-CELL |
| 13C: $n^+$ − GaAs LAYER |
| 13B: $p$ − GaAs LAYER |
| 13A: $p^+$ − GaAs LAYER |
| 20B : CONNECTION LAYER (Ti LAYER) |

| 20A : CONNECTION LAYER (Ti LAYER) |
| --- |
| 43 : $n^+$ − InP LAYER |
| 12 : SECOND SUB-CELL |
| 12C: $n^+$ − InGaAsP LAYER |
| 12B: $p$ − InGaAsP LAYER |
| 12A: $p^+$ − InGaAsP LAYER |
| 15 : FIRST TUNNEL JUNCTION LAYER |
| 11 : FIRST SUB-CELL |
| 11C : $n^+$ − InGaAs LAYER |
| 11B: $p$ − InGaAs LAYER |
| 11A: $p^+$ − InGaAs LAYER |
| 32 : SUPPORT SUBSTRATE |

| 44 : SUBSTRATE FOR FILM FORMATION |
| --- |
| 46 : SECOND SACRIFICIAL LAYER FOR PEELING-OFF |
| 17 : WINDOW LAYER |
| 14 : FOURTH SUB-CELL |
| 14C: $n^+$ − InGaP LAYER |
| 14B: $p$ − InGaP LAYER |
| 14A: $p^+$ − InGaP LAYER |
| 16 : SECOND TUNNEL JUNCTION LAYER |
| 13 : THIRD SUB-CELL |
| 13C: $n^+$ − GaAs LAYER |
| 13B: $p$ − GaAs LAYER |
| 13A: $p^+$ − GaAs LAYER |
| 20B : CONNECTION LAYER (Ti LAYER) |
| 20A : CONNECTION LAYER (Ti LAYER) |
| 43 : $n^+$ − InP LAYER |
| 12 : SECOND SUB-CELL |
| 12C: $n^+$ − InGaAsP LAYER |
| 12B: $p$ − InGaAsP LAYER |
| 12A: $p^+$ − InGaAsP LAYER |
| 15 : FIRST TUNNEL JUNCTION LAYER |
| 11 : FIRST SUB-CELL |
| 11C: $n^+$ − InGaAs LAYER |
| 11B: $p$ − InGaAs LAYER |
| 11A: $p^+$ − InGaAs LAYER |
| 32 : SUPPORT SUBSTRATE |

[ FIG. 7 ]

[STEP-420] (SUBSEQUENT STEP)

19    18

| 17 : WINDOW LAYER |
|---|
| 14 : FOURTH SUB-CELL |
| 14C: $n^+ - InGaP$ LAYER |
| 14B: $p - InGaP$ LAYER |
| 14A: $p^+ - InGaP$ LAYER |
| 16 : SECOND TUNNEL JUNCTION LAYER |
| 13 : THIRD SUB-CELL |
| 13C: $n^+ - GaAs$ LAYER |
| 13B: $p - GaAs$ LAYER |
| 13A: $p^+ - GaAs$ LAYER |
| 20B : CONNECTION LAYER (Ti LAYER) |
| 20A : CONNECTION LAYER (Ti LAYER) |
| 43 : $n^+ - InP$ LAYER |
| 12 : SECOND SUB-CELL |
| 12C: $n^+ - InGaAsP$ LAYER |
| 12B: $p - InGaAsP$ LAYER |
| 12A: $p^+ - InGaAsP$ LAYER |
| 15 : FIRST TUNNEL JUNCTION LAYER |
| 11 : FIRST SUB-CELL |
| 11C: $n^+ - InGaAs$ LAYER |
| 11B: $p - InGaAs$ LAYER |
| 11A: $p^+ - InGaAs$ LAYER |
| 32 : SUPPORT SUBSTRATE |

[ FIG. 8 ]

[EXAMPLE 5]

(A)  [STEP-500]

| 47 : THIRD SCRIFICIAL LAYER FOR PEELING-OFF |
| --- |
| 17 : WINDOW LAYER |
| 14 : FOURTH SUB-CELL |
| 14C: $n^+$ − InGaP LAYER |
| 14B: p − InGaP LAYER |
| 14A: $p^+$ − InGaP LAYER |
| 16 : SECOND TUNNEL JUNCTION LAYER |
| 13 : THIRD SUB-CELL |
| 13C: $n^+$ −GaAs LAYER |
| 13B: p −GaAs LAYER |
| 13A: $p^+$ −GaAs LAYER |
| 46 : SECOND SACRIFICIAL LAYER FOR PEELING-OFF |
| 44 : SUBSTRATE FOR FILM FORMATION |

| 11 : FIRST SUB-CELL |
| --- |
| 11A: $p^+$ − InGaAs LAYER |
| 11B: p − InGaAs LAYER |
| 11C: $n^+$ − InGaAs LAYER |
| 15 : FIRST TUNNEL JUNCTION LAYER |
| 12 : SECOND SUB-CELL |
| 12A: $p^+$ − InGaAsP LAYER |
| 12B: p − InGaAsP LAYER |
| 12C: $n^+$ − InGaAsP LAYER |
| 43 : $n^+$ − InP LAYER |
| 42 : FIRST SACRIFICIAL LAYER FOR PEELING-OFF |
| 41 : SUBSTRATE FOR FILM FORMATION |

(B)  [STEP-510]

| 47 : THIRD SACRIFICIAL LAYER FOR PEELING-OFF |
| --- |
| 17 : WINDOW LAYER |
| 14 : FOURTH SUB-CELL |
| 14C: $n^+$ − InGaP LAYER |
| 14B: p − InGaP LAYER |
| 14A: $p^+$ − InGaP LAYER |
| 16 : SECOND TUNNEL JUNCTION LAYER |
| 13 : THIRD SUB-CELL |
| 13C: $n^+$ −GaAs LAYER |
| 13B: p −GaAs LAYER |
| 13A: $p^+$ −GaAs LAYER |

| 11 : FIRST SUB-CELL |
| --- |
| 11A: $p^+$ − InGaAs LAYER |
| 11B: p − InGaAs LAYER |
| 11C: $n^+$ − InGaAs LAYER |
| 15 : FIRST TUNNEL JUNCTION LAYER |
| 12 : SECOND SUB-CELL |
| 12A: $p^+$ − InGaAsP LAYER |
| 12B: p − InGaAsP LAYER |
| 12C: $n^+$ − InGaAsP LAYER |
| 43 : $n^+$ − InP LAYER |

[ FIG.9 ]

(A)  [STEP-520]                    (B)  [STEP-530]

|                                     |
| ----------------------------------- |
| **34** : SUPPORT SUBSTRATE |

| **47** | : THIRD SACRIFICIAL LAYER : FOR PEELING-OFF |
| ------ | ------------------------ |
| **17** | : WINDOW LAYER |
| **14** | : FOURTH SUB-CELL |
| | **14C**: $n^+$ − InGaP LAYER |
| | **14B**: p  − InGaP LAYER |
| | **14A**: $p^+$ − InGaP LAYER |
| **16** | : SECOND TUNNEL JUNCTION LAYER |
| **13** | : THIRD SUB-CELL |
| | **13C**: $n^+$ − GaAs LAYER |
| | **13B**: p  − GaAs LAYER |
| | **13A**: $p^+$ − GaAs LAYER |
| **20B** | : CONNECTION LAYER (Ti LAYER) |

| **47** | : THIRD SACRIFICIAL LAYER : FOR PEELING-OFF |
| ------ | ------------------------ |
| **17** | : WINDOW LAYER |
| **14** | : FOURTH SUB-CELL |
| | **14C**: $n^+$ − InGaP LAYER |
| | **14B**: p  − InGaP LAYER |
| | **14A**: $p^+$ − InGaP LAYER |
| **16** | : SECOND TUNNEL JUNCTION LAYER |
| **13** | : THIRD SUB-CELL |
| | **13C**: $n^+$ − GaAs LAYER |
| | **13B**: p  − GaAs LAYER |
| | **13A**: $p^+$ − GaAs LAYER |
| **20B** | : CONNECTION LAYER (Ti LAYER) |

| **20A** | : CONNECTION LAYER (Ti LAYER) |
| ------- | ----------------------------- |
| **43** | : $n^+$ − InP LAYER |
| **12** | : SECOND SUB-CELL |
| | **12C**: $n^+$ − InGaAsP LAYER |
| | **12B**: p  − InGaAsP LAYER |
| | **12A**: $p^+$ − InGaAsP LAYER |
| **15** | : FIRST TUNNEL JUNCTION LAYER |
| **11** | : FIRST SUB-CELL |
| | **11C**: $n^+$ − InGaAs LAYER |
| | **11B**: p  − InGaAs LAYER |
| | **11A**: $p^+$ − InGaAs LAYER |

| **20A** | : CONNECTION LAYER (Ti LAYER) |
| ------- | ----------------------------- |
| **43** | : $n^+$ − InP LAYER |
| **12** | : SECOND SUB-CELL |
| | **12C**: $n^+$ − InGaAsP LAYER |
| | **12B**: p  − InGaAsP LAYER |
| | **12A**: $p^+$ − InGaAsP LAYER |
| **15** | : FIRST TUNNEL JUNCTION LAYER |
| **11** | : FIRST SUB-CELL |
| | **11C**: $n^+$ − InGaAs LAYER |
| | **11B**: p  − InGaAs LAYER |
| | **11A**: $p^+$ − InGaAs LAYER |
| **33** : SUPPORT SUBSTRATE | |

[ FIG. 10 ]

(A)  [STEP-540]

| |
|---|
| 34: SUPPORT SUBSTRATE |
| 47 : THIRD SACRIFICIAL LAYER FOR PEELING-OFF |
| 17 : WINDOW LAYER |
| 14 : FOURTH SUB-CELL |
| 14C: n⁺−InGaP LAYER |
| 14B: p −InGaP LAYER |
| 14A: p⁺−InGaP LAYER |
| 16 : SECOND TUNNEL JUNCTION LAYER |
| 13 : THIRD SUB-CELL |
| 13C: n⁺−GaAs LAYER |
| 13B: p −GaAs LAYER |
| 13A: p⁺−GaAs LAYER |
| 20B: CONNECTION LAYER (Ti LAYER) |
| 20A: CONNECTION LAYER (Ti LAYER) |
| 43 : n⁺−InP LAYER |
| 12 : SECOND SUB-CELL |
| 12C: n⁺−InGaAsP LAYER |
| 12B: p −InGaAsP LAYER |
| 12A: p⁺−InGaAsP LAYER |
| 15 : FIRST TUNNEL JUNCTION LAYER |
| 11 : FIRST SUB-CELL |
| 11C: n⁺−InGaAs LAYER |
| 11B: p −InGaAs LAYER |
| 11A: p⁺−InGaAs LAYER |
| 33: SUPPORT SUBSTRATE |

(B)  [STEP-540] (SUBSEQUENT STEP)

19    18

| |
|---|
| 17 : WINDOW LAYER |
| 14 : FOURTH SUB-CELL |
| 14C: n⁺−InGaP LAYER |
| 14B: p −InGaP LAYER |
| 14A: p⁺−InGaP LAYER |
| 16 : SECOND TUNNEL JUNCTION LAYER |
| 13 : THIRD SUB-CELL |
| 13C: n⁺−GaAs LAYER |
| 13B: p −GaAs LAYER |
| 13A: p⁺−GaAs LAYER |
| 20B: CONNECTION LAYER (Ti LAYER) |
| 20A: CONNECTION LAYER (Ti LAYER) |
| 43 : n⁺−InP LAYER |
| 12 : SECOND SUB-CELL |
| 12C: n⁺−InGaAsP LAYER |
| 12B: p −InGaAsP LAYER |
| 12A: p⁺−InGaAsP LAYER |
| 15 : FIRST TUNNEL JUNCTION LAYER |
| 11 : FIRST SUB-CELL |
| 11C: n⁺−InGaAs LAYER |
| 11B: p −InGaAs LAYER |
| 11A: p⁺−InGaAs LAYER |
| 33: SUPPORT SUBSTRATE |

[ FIG. 11 ]

| 107 : SECOND ELECTRODE |
|---|

| 103 : THIRD SEMICONDUCTOR LASER DEVICE |
|---|
| 103C: n−AlGaInP LAYER |
| 103B: InGaP LAYER |
| 103A: p−AlGaInP LAYER |

| 105 : TUNNEL JUNCTION LAYER |
|---|

| 102 : SECOND SEMICONDUCTOR LASER DEVICE |
|---|
| 102C: n−AlGaAs LAYER |
| 102B: InGaAs LAYER |
| 102A: p−AlGaAs LAYER |

| 104 : CONNECTION LAYER |
|---|

| 101 : FIRST SEMICONDUCTOR LASER DEVICE |
|---|
| 101C: n−InP LAYER |
| 101B: InGaAsP LAYER |
| 101A: p−InP LAYER |

| 106 : FIRST ELECTRODE |
|---|

[ FIG. 12 ]

[ FIG. 13 ]

(A)

| UPPER ELECTRODE 307 |
| WINDOW LAYER 306 |
| SOLAR CELL 305 |
| COMPOUND SEMICONDUC -TOR LAYER 304 |

| CONNECTION LAYER 303 |
| SEMICONDUCTOR LASER DEVICE |
| COMPOUND SEMICONDUC -TOR LAYER 302C |
| COMPOUND SEMICONDUC -TOR LAYER 302B |
| COMPOUND SEMICONDUC -TOR LAYER 302A |
| LOWER ELECTRODE 301 |

(B)

| UPPER ELECTRODE 407 |
| WINDOW LAYER 406 |
| SOLAR CELL 405 |
| COMPOUND SEMICONDUC -TOR LAYER 404 |

| CONNECTION LAYER 403 |
| SEMICONDUCTOR LASER DEVICE |
| COMPOUND SEMICONDUC -TOR LAYER 402D |
| COMPOUND SEMICONDUC -TOR LAYER 402C |
| COMPOUND SEMICONDUC -TOR LAYER 402B |
| COMPOUND SEMICONDUC -TOR LAYER 402A |
| LOWER ELECTRODE 401 |

[ FIG. 14 ]

19    18

| 17 : WINDOW LAYER | |
|---|---|
| **14** : FOURTH SUB-CELL | |
| | 14C: n⁺−InGaP LAYER |
| | 14B: p −InGaP LAYER |
| | 14A: p⁺−InGaP LAYER |
| 16 : SECOND TUNNEL JUNCTION LAYER | |
| **13** : THIRD SUB-CELL | |
| | 13C: n⁺−GaAs LAYER |
| | 13B: p −GaAs LAYER |
| | 13A: p⁺−GaAs LAYER |

$14C: n^+-InGaP$ LAYER
$14B: p \ -InGaP$ LAYER
$14A: p^+-InGaP$ LAYER
$13C: n^+-GaAs$ LAYER
$13B: p \ -GaAs$ LAYER
$13A: p^+-GaAs$ LAYER

THIRD ELECTRODE

| **20B** : CONNECTION LAYER (Ti LAYER) |
| **20A** : CONNECTION LAYER (Ti LAYER) |
| **12** : SECOND SUB-CELL |

$12A: p^+-InGaAsP$ LAYER
$12B: p \ -InGaAsP$ LAYER
$12C: n^+-InGaAsP$ LAYER

| 15 : FIRST TUNNEL JUNCTION LAYER |
| **11** : FIRST SUB-CELL |

$11A: n^+-InGaAs$ LAYER
$11B: p \ -InGaAs$ LAYER
$11C: p^+-InGaAs$ LAYER

| 31 : SUBSTRATE FOR FILM-FORMATION /SUPPORT |
| FIRST ELECTRODE |

[ FIG. 15 ]

BINDING ENERGY BETWEEN ADATOM AND SUBSTRATE ╱ kT

SUBSTRATE : GaAs InP

[ FIG. 16 ]

[ FIG. 17 ]

BLACK

NOT TRANSMITTED

TRANSMITTED

GRAY

[ FIG. 18 ]

[ FIG. 19 ]

[ FIG. 20 ]

STEM OBSERVATION OF JUNCTION INTERFACE

[ FIG. 21 ]

[ FIG. 22 ]

[ FIG. 23 ]

[ FIG. 24 ]

## INTERNATIONAL SEARCH REPORT

| International application No. |
| --- |
| PCT/JP2012/072330 |

A.   CLASSIFICATION OF SUBJECT MATTER
*H01L31/0735*(2012.01)i,  *H01L31/0725*(2012.01)i,  *H01S5/40*(2006.01)i

According to International Patent Classification (IPC) or to both national classification and IPC

B.   FIELDS SEARCHED

Minimum documentation searched (classification system followed by classification symbols)
H01L31, H01S5

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| X | JP 63-157482 A  (Kaneka Corp.), 30 June 1988 (30.06.1988), (Family: none) | 1-18 |
| X | WO 2010/143342 A1  (Panasonic Corp.), 16 December 2010 (16.12.2010), & JP 2010-283255 A | 1-18 |
| X | JP 2001-85718 A  (Toyota Motor Corp.), 30 March 2001 (30.03.2001), (Family: none) | 1-18 |
| X | JP 2000-340509 A  (Sumitomo Electric Industries, Ltd.), 08 December 2000 (08.12.2000), (Family: none) | 10-18 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 11 October, 2012 (11.10.12) | 23 October, 2012 (23.10.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

46

**INTERNATIONAL SEARCH REPORT**

| International application No. |
| --- |
| PCT/JP2012/072330 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | J.M.Zahler, "Wafer Bonding and Layer Transfer Processes for High Efficiency Solar Cells", NCPV and Solar Program Review Meeting 2003, p.1-4 | 1-18 |

Form PCT/ISA/210 (continuation of second sheet) (July 2009)

## INTERNATIONAL SEARCH REPORT

International application No.

PCT/JP2012/072330

**Box No. II       Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III       Observations where unity of invention is lacking (Continuation of item 3 of first sheet)**

This International Searching Authority found multiple inventions in this international application, as follows:

The invention set forth in claims 1 to 9 relates to a multi-junction solar cell, whereas the inventions set forth in claims 10 to 16, claim 17, and claim 18 relate to a compound semiconductor device, a photoelectric conversion element, and a compound semiconductor layer laminate structure, respectively. Therefore, the subject matters are different. Accordingly, the present international application includes at least four inventions.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**       ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 201110281336

**Non-patent literature cited in the description**

• Wafer Bonding and Layer Transfer Processes for High Efficiency Solar Cells. *NCPV and Solar Program Review Meeting,* 2003